# EUROPEAN PATENT APPLICATION

(11) **EP 4 629 801 A1**
(43) Date of publication of application: **08.10.2025**
(21) Application number: 25165462.0
(22) Date of filing: 21.03.2025
(51) Int. Cl.: H10K 59/131

(54) **DISPLAY DEVICE**

(30) Priority: 29.03.2024 KR 20240043461
(71) Applicant: Samsung Display Co., Ltd., Yongin-si, Gyeonggi-do 17113 (KR)
(72) Inventor: CHO, Young Jin, 17113 Yongin-si (KR); KIM, Il Joo, 17113 Yongin-si (KR); YOUN, Jung Soo, 17113 Yongin-si (KR); LEE, Chang Yeol, 17113 Yongin-si (KR); MOON, Joong Soo, 17113 Yongin-si (KR); LEE, Seung Hee, 17113 Yongin-si (KR)
(74) Representative: Walaski, Jan Filip

(57) **Abstract**

A display device includes: a display panel; a pixel in a display area of the display panel; a plurality of circuit boards connected to a non-display area of the display panel; and a plurality of driving circuits on the circuit boards, wherein each of the circuit boards comprises a group terminal connected to pads of the non-display area, the group terminal comprises a plurality of terminals adjacent to each other on a corresponding circuit board, and group terminals of at least two circuit boards have different widths.

## Description

### CROSS-REFERENCE TO RELATED APPLICATION

The present application claims priority to Korean Patent Application No. 10-2024-0043461, filed on 29 March 2024 in the Korean Intellectual Property Office.

### BACKGROUND

### 1. Field

The present disclosure relates to a display device.

### 2. Description of the Related Art

Organic light emitting diode displays have self-luminous properties and, unlike liquid crystal displays, generally do not require a separate light source and thus can be relatively reduced in thickness and weight. In addition, organic light emitting diode displays are attracting attention as next-generation displays for televisions, monitors, and portable electronic devices due to their high-quality characteristics such as relatively low power consumption, relatively high luminance, and relatively high response speed.

As the resolution of a display device increases, the display device includes a greater number of data lines. Accordingly, a greater number of driving circuits and a greater number of circuit boards may be required to drive the data lines. Therefore, as the resolution of a display device increases, a gap between circuit boards and a terminal pitch of the circuit boards may inevitably decrease because a large number of driving circuits are attached within a limited area of a display panel.

Alignment between circuit boards is checked using an alignment key located between the circuit boards. When a gap between terminals of the circuit boards is reduced as described above, an area for placing the alignment key may not be sufficient, which may make it difficult to form the alignment key. In this case, the circuit boards may be misaligned. In addition, a reduced terminal pitch of a circuit board may cause misalignment between terminals of the circuit board and pads of a display panel.

The above information disclosed in this Background section is only for enhancement of understanding of the background and therefore the information discussed in this Background section does not necessarily constitute prior art.

### SUMMARY

Aspects of some embodiments of the present disclosure relate to a display device, and for example, to a display device which can minimize misalignment of a circuit board at high resolution.

Aspects of some embodiments of the present disclosure include a display device which can minimize or reduce misalignment of a circuit board at high resolution.

According to some embodiments of the disclosure, display device comprising: a display panel; a pixel in a display area of the display panel; a plurality of circuit boards connected to a non-display area of the display panel; and a plurality of driving circuits on the circuit boards, wherein each of the circuit boards comprises a group terminal connected to pads of the non-display area, the group terminal comprises a plurality of terminals adjacent to each other on a corresponding circuit board, and group terminals of at least two circuit boards have different widths.

According to some embodiments, the circuit boards include: a first outermost circuit board; a second outermost circuit board; and a middle circuit board between the first outermost circuit board and the second outermost circuit board.

According to some embodiments, a group terminal of at least one of the first outermost circuit board or the second outermost circuit board or a group terminal of the middle circuit board have different widths.

According to some embodiments, a width of the group terminal of the middle circuit board is smaller than a width of the group terminal of the at least one of the first outermost circuit board or the second outermost circuit board.

According to some embodiments, further comprising a first alignment key between adjacent circuit boards.

According to some embodiments, the first alignment key is between the first outermost circuit board and the middle circuit board.

According to some embodiments, a distance between any one of facing sides of the first outermost circuit board and the middle circuit board and a center of the first alignment key is equal to a distance between the other one of the facing sides and the center of the first alignment key.

According to some embodiments, a distance between any one of facing sides of a terminal of the first outermost circuit board and a terminal of the middle circuit board and the center of the first alignment key is different from a distance between the other one of the facing sides and the center of the first alignment key.

According to some embodiments, the any one of the facing sides is a side of the terminal of the first outermost circuit board, and the other one of the facing sides is a side of the terminal of the first outermost circuit board.

According to some embodiments, the first alignment key is between the second outermost circuit board and the middle circuit board.

According to some embodiments, a distance between any one of facing sides of the second outermost circuit board and the middle circuit board and the center of the first alignment key is equal to a distance between the other one of the facing sides and the center of the first alignment key.

According to some embodiments, a distance between any one of facing sides of a terminal of the second outermost circuit board and a terminal of the middle circuit board and the center of the first alignment key is different from a distance between the other one of the facing sides and the center of the first alignment key.

According to some embodiments, the any one of the facing sides is a side of the terminal of the second outermost circuit board, the other one of the facing sides is a side of the terminal of the second outermost circuit board, and the distance between the any one of the facing sides and the first alignment key is greater than the distance between the other one of the facing sides and the first alignment key.

According to some embodiments, the middle circuit board comprises a first middle circuit board and a second middle circuit board, and the first alignment key is between the first middle circuit board and the second middle circuit board.

According to some embodiments, a distance between any one of facing sides of the first middle circuit board and the second middle circuit board and the center of the first alignment key is equal to a distance between the other one of the facing sides and the center of the first alignment key.

According to some embodiments, a distance between any one of facing sides of a terminal of the first middle circuit board and a terminal of the second middle circuit board and the center of the first alignment key is equal to a distance between the other one of the facing sides and the center of the first alignment key.

According to some embodiments, at least two of the circuit boards have different widths.

According to some embodiments, circuit boards having group terminals of different widths have different widths.

According to some embodiments, a circuit board comprising a group terminal having a greater width has a greater width than a circuit board comprising a group terminal having a smaller width.

According to some embodiments, further comprising a fan-out line connected to a side of each of the pads and the pixel.

According to some embodiments, further comprising a dummy line connected to the other side of each of the pads.

According to some embodiments, further comprising a second alignment key between adjacent dummy lines.

According to some embodiments, the second alignment key is on the same layer as an active layer of the pixel.

According to some embodiments, the second alignment key has a triangular shape.

According to some embodiments, a plurality of group pads comprising adjacent pads among the pads are connected to a plurality of group terminals.

According to some embodiments, the second alignment key comprises a plurality of alignment keys, and the alignment keys are near an imaginary center line passing through a portion of a group pad, which corresponds to a half of a width of the group pad, and extending parallel to a pad along a direction in which the pad extends.

According to some embodiments, when a total number of pads included in the group pad is an odd number, the center line is located at a center of a center pad at a center of the group pad, and the alignment keys are on both sides of a dummy line connected to the center pad.

According to some embodiments, when the total number of pads included in the group pad is an even number, the alignment keys are on both sides of an n-th dummy line to the left of the center line, where n is a natural number less than k/2, and k is the total number of pads included in the group pads.

According to some embodiments, when the total number of pads included in the group pad is an even number, the alignment keys are on both sides of an n-th dummy line to the right of the center line, where n is a natural number less than k/2, and k is the total number of pads included in the group pads.

According to some embodiments, the second alignment key comprises a plurality of alignment keys on both sides of a dummy line with the dummy line interposed therebetween, and each of the alignment keys have a triangular shape.

According to some embodiments, the pads comprise an outermost group pad connected to the first outermost circuit board and a middle group pad connected to the middle circuit board, and a distance between any one of facing sides of a pad included in the outermost group pad and a pad included in the middle group pad and the center of the first alignment key is different from a distance between the other one of the facing sides and the center of the first alignment key.

According to some embodiments, the distance between the any one of the facing sides and the center of the first alignment key is greater than the distance between the other one of the facing sides and the first alignment key.

According to some embodiments, gaps between adjacent circuit boards are equal.

However, aspects of embodiments according to the present disclosure are not restricted to those specifically set forth herein. The above and other aspects of embodiments according to the present disclosure will become more apparent to one of ordinary skill in the art to which the present disclosure pertains by referencing the detailed description of the present disclosure given below.

### BRIEF DESCRIPTION OF THE DRAWINGS

These and/or other aspects will become apparent and more readily appreciated from the following description of the embodiments, taken in conjunction with the accompanying drawings in which:
FIG. 1 is a plan view of a display device;
FIG. 2 is a plan view of a display panel of FIG. 1;
FIG. 3 is an enlarged view of the part A1 of FIG. 1;
FIG. 4 is an enlarged view of the part A2 of FIG. 1;
FIG. 5 is an enlarged view of the part A3 of FIG. 2;
FIG. 6 is an enlarged view of the part A4 of FIG. 2;
FIG. 7 is a circuit diagram of a pixel of the display device;
FIG. 8 is a cross-sectional view of the display;
FIG. 9 is an enlarged view of the part A5 of FIG. 2;
FIG. 10 is a cross-sectional view taken along the line I-I' of FIG. 9;
FIG. 11 is a cross-sectional view taken along the line II-II' of FIG. 9;
FIG. 12 is a cross-sectional view taken along the line III-III' of FIG. 9;
FIG. 13 is a cross-sectional view taken along the line IV-IV' of FIG. 9;
FIG. 14 is a diagram illustrating the position of fifth alignment keys when the number of pads in a group pad is an odd number; and
FIG. 15 is a diagram illustrating the position of fifth alignment keys when the number of pads in a group pad is an even number.

### DETAILED DESCRIPTION

Aspects of some embodiments of the present invention will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

Hereinafter, aspects of some embodiments will be described with reference to the accompanying drawings.

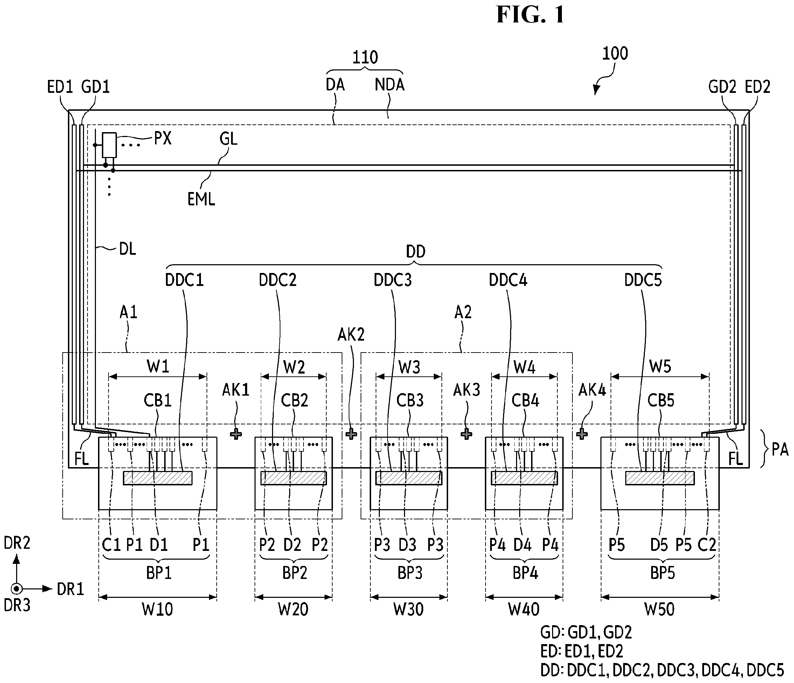

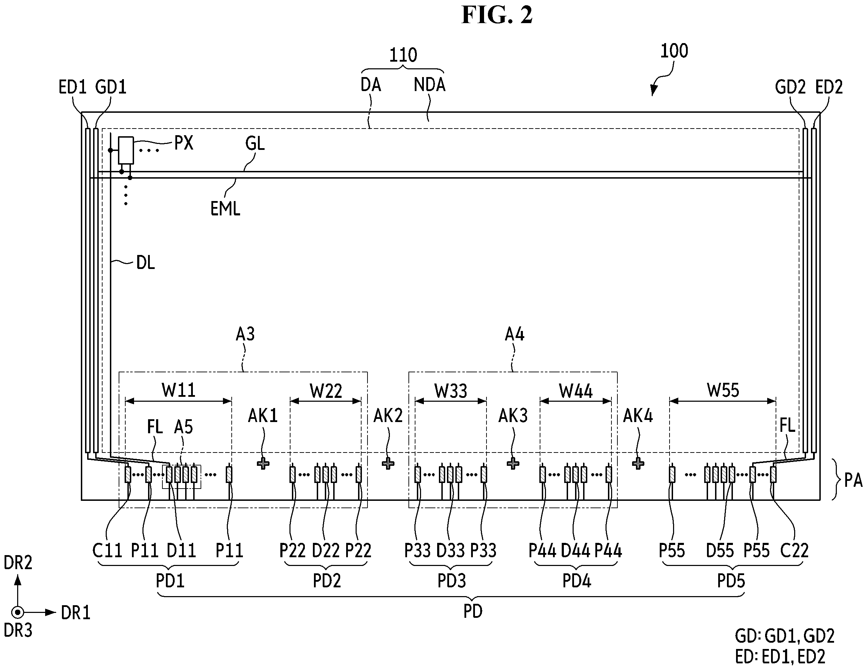

FIG. 1 is a plan view of a display device 100. FIG. 2 is a plan view of a display panel 110 of FIG. 1. For example, FIG. 2 illustrates components of FIG. 1 excluding a data driver DD.

Referring to FIGS. 1 and 2, the display device 100 is a device for displaying moving images or still images. The display device 100 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards, and Internet of things (IoT) devices. These are presented merely as examples, and the display device 100 can also be employed in other electronic devices.

The display device 100 may be a light emitting display device such as an organic light emitting diode display device including an organic light emitting diode, a quantum dot light emitting display device including a quantum dot light emitting layer, an inorganic light emitting display device including an inorganic semiconductor, or an ultra-small light emitting display device including an ultra-small light emitting diode such as a micro- or nano-light emitting diode. However, it is not limited thereto. For example, the display device 100 may also be a display device of a type other than a light emitting display device. Embodiments in which the display device 100 is a light emitting display device (e.g., an organic light emitting diode display device) will be disclosed in more detail below.

The display device 100 may include the display panel 110 and a gate driver GD, an emission driver ED and the data driver DD which supply driving signals to pixels PX of the display panel 110. Here, the pixels PX may be located in a display area DA of the display panel 110, the gate driver GD and the emission driver ED may be located in a non-display area NDA of the display panel 110, and the data driver DD may be connected to the non-display area NDA of the display panel 110 through a circuit board.

The display device 100 may further include a power supply unit and a timing controller. The power supply unit may supply power supply voltages to the pixels PX, the gate driver GD, the emission driver ED, and the data driver DD. The timing controller may control the operations of a first gate driver GD1, a second gate driver GD2, a first emission driver ED1, a second emission driver ED2, and the data driver DD.

The display panel 110 may have a rectangular shape in a plan view (e.g., from a view perpendicular or normal with respect to a display surface of the display panel 110). Although a horizontal length of the display panel 110 is longer than a vertical length in FIGS. 1 and 2, the shape of the display panel 110 is not limited thereto. For example, the display panel 110 may also have a shape whose vertical length is longer than a horizontal length or may have a square shape. The display panel 110 may include angled corners or rounded corners.

The planar shape of the display panel 110 is not limited to the illustrated quadrangular shape, and other shapes can also be applied. For example, the display panel 110 may have a polygonal shape other than a quadrangular shape, a circular shape, an elliptical shape, an irregular shape, or other shapes in a plan view.

The display panel 110 may be provided as a rigid panel that is substantially not deformed or may be provided as a flexible panel that can be folded, bent, or rolled in at least one part without damaging the display panel 110. The display panel 110 may be provided in the display device 100 in an unbent state or may be provided in the display device 100 in a partially bent state.

The display panel 110 may include the display area DA and the non-display area NDA.

A plurality of pixels PX may be located in the display area DA. The pixels PX may display images. The pixels PX may be connected to gate lines GL, emission control lines EML, data lines DL, and power lines. The gate lines GL and the emission control lines EML may extend along a first direction DR1, and the data lines DL may extend along a second direction DR2.

The non-display area NDA may be located around (e.g., in a periphery or outside a footprint of) the display area DA. The non-display area NDA may surround the display area DA.

The display area DA may have various shapes. For example, the display area DA may have a quadrangular shape, a polygonal shape other than a quadrangular shape, a circular shape, an elliptical shape, an irregular shape, or other shapes. The display area DA may have a shape that matches or conforms to the shape of the display panel 110.

As illustrated in FIG. 2, the non-display area NDA may include a pad area PA where a plurality of pads PD are located. For example, the pad area PA may be located in the non-display area NDA (e.g., a lower non-display area) located below the display area DA. The pads PD may be arranged along the first direction DR1.

The gate driver GD and the emission driver ED may be located in the non-display area NDA. For example, the gate driver GD may include the first gate driver GD1 and the second gate driver GD2, and the emission driver ED may include the first emission driver ED1 and the second emission driver ED2. Here, the first gate driver GD1 and the first emission driver ED1 may be located in the non-display area NDA (e.g., a left non-display area) located on a left side of the display area DA, and the second gate driver GD2 and the second emission driver ED2 may be located in the non-display area NDA (e.g., a right non-display area) located on a right side of the display area DA.

The gate driver GD may drive the gate lines GL. For example, each of the first gate driver GD1 and the second gate driver GD2 may supply gate signals to the gate lines GL. The gate lines GL may be connected to the first gate driver GD1 and the second gate driver GD2. For example, one side of each gate line GL may be electrically connected to the first gate driver GD1, and the other side of each gate line GL may be electrically connected to the second gate driver GD2.

The emission driver ED may drive the emission control lines EML. For example, each of the first emission driver ED1 and the second emission driver ED2 may supply emission control signals to the emission control lines EML. The emission control lines EML may be connected to the first emission driver ED1 and the second emission driver ED2. For example, one side of each emission control line EML may be electrically connected to the first emission driver ED1, and the other side of each emission control line EML may be electrically connected to the second emission driver ED2.

Circuit boards CB1 through CB5 may be electrically connected to the display panel 110 through the pads PD as illustrated in FIGS. 1 and 2. The circuit boards CB1 through CB5 may include a first circuit board CB1, a second circuit board CB2, a third circuit board CB3, a fourth circuit board CB4, and a fifth circuit board CB5. The first through fifth circuit boards CB1 through CB5 may be connected to at least one of the timing controller or the power supply unit through another circuit board or a connector. Each of the circuit boards CB1 through CB5 may be, but is not limited to, a flexible printed circuit board (FPCB), a printed circuit board (PCB), or a flexible film such as a chip on film (COF).

Gaps (e.g., in the first direction DR1) between adjacent circuit boards may be equal. For example, a gap between the first circuit board CB1 and the second circuit board CB2, a gap between the second circuit board CB2 and the third circuit board CB3, a gap between the third circuit board CB3 and the fourth circuit board CB4, and a gap between the fourth circuit board CB4 and the fifth circuit board CB5 may be equal.

Each of the circuit boards CB1 through CB8 may include a group terminal (or a group bump). For example, the first circuit board CB1 may include a first group terminal BP1, the second circuit board CB2 may include a second group terminal BP2, the third circuit board CB3 may include a third group terminal BP3, the fourth circuit board CB4 may include a fourth group terminal BP4, and the fifth circuit board CB5 may include a fifth group terminal BP5.

The first group terminal BP1 may include a plurality of first terminals (or bumps) C1, P1 and D1 located adjacent to each other on the first circuit board CB1. The second group terminal BP2 may include a plurality of second terminals P2 and D2 located adjacent to each other on the second circuit board CB2. The third group terminal BP3 may include a plurality of third terminals P3 and D3 located adjacent to each other on the third circuit board CB3. The fourth group terminal BP4 may include a plurality of fourth terminals P4 and D4 located adjacent to each other on the fourth circuit board CB4. The fifth group terminal BP5 may include a plurality of fifth terminals C2, P5 and D5 located adjacent to each other on the fifth circuit board CB5. Although five circuit boards CB1 through CB5 are disclosed, the number of circuit boards is not limited thereto.

The data driver DD may include a plurality of driving circuits DDC1 through DDC5 (hereinafter, referred to as data driving circuits) arranged along the first direction DR1. For example, the data driver DD may include a first data driving circuit DDC1 mounted on the first circuit board CB1, a second data driving circuit DDC2 mounted on the second circuit board CB2, a third data driving circuit DDC3 mounted on the third circuit board CB3, a fourth data driving circuit DDC4 mounted on the fourth circuit board CB4, and a fifth data driving circuit DDC5 mounted on the fifth circuit board CB5. Each of the data driving circuits DDC1 through DDC5 may include, for example, an integrated circuit.

Each of the data driving circuits DDC1 through DDC5 may be electrically connected to the pads PD of the display panel 110 through one of the circuit boards CB1 through CB5. For example, the first data driving circuit DDC1 may electrically be connected to first pads C11, P11 and D11 of the display panel 110 through the first terminals C1, P1 and D1 of the first circuit board CB1, the second data driving circuit DDC2 may be electrically connected to second pads P22 and D22 of the display panel 110 through the second terminals P2 and D2 of the second circuit board CB2, the third data driving circuit DDC3 may be electrically connected to third pads P33 and D33 of the display panel 110 through the third terminals P3 and D3 of the third circuit board CB3, the fourth data driving circuit DDC4 may be electrically connected to fourth pads P44 and D44 of the display panel 110 through the fourth terminals P4 and D4 of the fourth circuit board CB4, and the fifth data driving circuit DDC5 may be electrically connected to fifth pads C22, P55 and D55 of the display panel 110 through the fifth terminals C2, P5 and D5 of the fifth circuit board CB5.

The data lines DL may be connected to the data driver DD. For example, the data lines DL may be divided and connected to the data driving circuits DDC1 through DDC5. The data lines DL may include a plurality of first data lines connected to the first data driving circuit DDC1, a plurality of second data lines connected to the second data driving circuit DDC2, a plurality of third data lines connected to the third data driving circuit DDC3, a plurality of fourth data lines connected to the fourth data driving circuit DDC4, and a plurality of fifth data lines connected to the fifth data driving circuit DDC5.

The first terminals C1, P1 and D1 (e.g., the first group terminal BP1) may include a plurality of first control terminals C1, a plurality of first power terminals P1 and a plurality of first data terminals D1 arranged along the first direction DR1 on the first circuit board CB1. The first control terminals C1 may be connected to the timing controller located on another circuit board (hereinafter, referred to as an external circuit board). The first power terminals P1 may be connected to the power supply unit located on the external circuit board. The first data terminals D1 may be connected to the first data driving circuit DDC1.

The second terminals P2 and D2 (e.g., the second group terminal BP2) may include a plurality of second power terminals P2 and a plurality of second data terminals D2 arranged along the first direction DR1 on the second circuit board CB2. The second power terminals P2 may be connected to the power supply unit located on the external circuit board. The second data terminals D2 may be connected to the second data driving circuit DDC2.

The third terminals P3 and D3 (e.g., the third group terminal BP3) may include a plurality of third power terminals P3 and a plurality of third data terminals D3 arranged along the first direction DR1 on the third circuit board CB3. The third power terminals P3 may be connected to the power supply unit located on the external circuit board. The third data terminals D3 may be connected to the third data driving circuit DDC3.

The fourth terminals P4 and D4 (e.g., the fourth group terminal BP4) may include a plurality of fourth power terminals P4 and a plurality of fourth data terminals D4 arranged along the first direction DR1 on the fourth circuit board CB4. The fourth power terminals P4 may be connected to the power supply unit located on the external circuit board. The fourth data terminals D4 may be connected to the fourth data driving circuit DDC4.

The fifth terminals C2, P5 and D5 (e.g., the fifth group terminal BP5) may include a plurality of second control terminals C2, a plurality of fifth power terminals P5 and a plurality of fifth data terminals D5 arranged along the first direction DR1 on the fifth circuit board CB5. The second control terminals C2 may be connected to the timing controller located on the external circuit board. The fifth power terminals P5 may be connected to the power supply unit located on the external circuit board. The fifth data terminals D5 may be connected to the fifth data driving circuit DDC5.

The first terminals C1, P1 and D1 of the first circuit board CB1, the second terminals P2 and D2 of the second circuit board CB2, the third terminals P3 and D3 of the third circuit board CB3, the fourth terminals P4 and D4 of the fourth circuit board CB4, and the fifth terminals C2, P5 and D5 of the fifth circuit board CB5 described above may be connected to the first pads C11, P11 and D11, the second pads P22 and D22, the third pads P33 and D33, the fourth pads P44 and D44, and the fifth pads C22, P55 and D55, respectively.

The first terminals C1, P1 and D1 and the first pads C11, P11 and D11 may be electrically connected directly or through a connection member such as a conductive ball. The second terminals P2 and D2 and the second pads P22 and D22 may be electrically connected directly or through a connection member such as a conductive ball. The third terminals P3 and D3 and the third pads P33 and D33 may be electrically connected directly or through a connection member such as a conductive ball. The fourth terminals P4 and D4 and the fourth pads P44 and D44 may be electrically connected directly or through a connection member such as a conductive ball. The fifth terminals C2, P5 and D5 and the fifth pads C22, P55 and D55 may be electrically connected directly or through a connection member such as a conductive ball.

The first pads C11, P11 and D11 may include a plurality of first control pads C11, a plurality of first power pads P11 and a plurality of first data pads D11 arranged along the first direction DR1 on the pad area PA of the display panel 110. The first control pads C11 may be connected to the first control terminals C1, respectively. In addition, the first control pads C11 may be connected to the first gate driver GD1 and the first emission driver ED1. The first power pads P11 may be connected to the first power terminals P1, respectively. In addition, the first power pads P11 may be connected to the first gate driver GD1, the first emission driver ED1, and the pixels PX. The first data pads D11 may be connected to the first data terminals D1, respectively. In addition, the first data pads D11 may be connected to the first data lines, respectively.

The second pads P22 and D22 may include a plurality of second power pads P22 and a plurality of second data pads D22 arranged along the first direction DR1 on the pad area PA of the display panel 110. The second power pads P22 may be connected to the second power terminals P2, respectively. In addition, the second power pads P22 may be connected to the pixels PX. The second data pads D22 may be connected to the second data terminals D2, respectively. In addition, the second data pads D22 may be connected to the second data lines, respectively.

The third pads P33 and D33 may include a plurality of third power pads P33 and a plurality of third data pads D33 arranged along the first direction DR1 on the pad area PA of the display panel 110. The third power pads P33 may be connected to the third power terminals P3, respectively. In addition, the third power pads P33 may be connected to the pixels PX. The third data pads D33 may be connected to the third data terminals D3, respectively. In addition, the third data pads D33 may be connected to the third data lines, respectively.

The fourth pads P44 and D44 may include a plurality of fourth power pads P44 and a plurality of fourth data pads D44 arranged along the first direction DR1 on the pad area PA of the display panel 110. The fourth power pads P44 may be connected to the fourth power terminals P4, respectively. In addition, the fourth power pads P44 may be connected to the pixels PX. The fourth data pads D44 may be connected to the fourth data terminals D4, respectively. In addition, the fourth data pads D44 may be connected to the fourth data lines, respectively.

The fifth pads C22, P55 and D55 may include a plurality of second control pads C22, a plurality of fifth power pads P55 and a plurality of fifth data pads D55 arranged along the first direction DR1 on the pad area PA of the display panel 110. The second control pads C22 may be connected to the second control terminals C2, respectively. In addition, the second control pads C22 may be connected to the second gate driver GD2 and the second emission driver ED2. The fifth power pads P55 may be connected to the fifth power terminals P5, respectively. In addition, the fifth power pads P55 may be connected to the pixels PX. The fifth data pads D55 may be connected to the fifth data terminals D5, respectively. In addition, the fifth data pads D55 may be connected to the fifth data lines, respectively.

The above-described first control pads C11 and the first gate driver GD1 may be electrically connected to each other through corresponding fan-out lines FL, and the other first control pads C11 and the first emission driver ED1 may be electrically connected to each other through corresponding fan-out lines FL.

The above-described second control pads C22 and the second gate driver GD2 may be electrically connected to each other through corresponding fan-out lines FL, and the other second control pads C22 and the second emission driver ED2 may be electrically connected to each other through corresponding fan-out lines FL.

The first through fifth data pads D11, D22, D33, D44 and D55 described above may be electrically connected to the first through fifth data lines through corresponding fan-out lines FL.

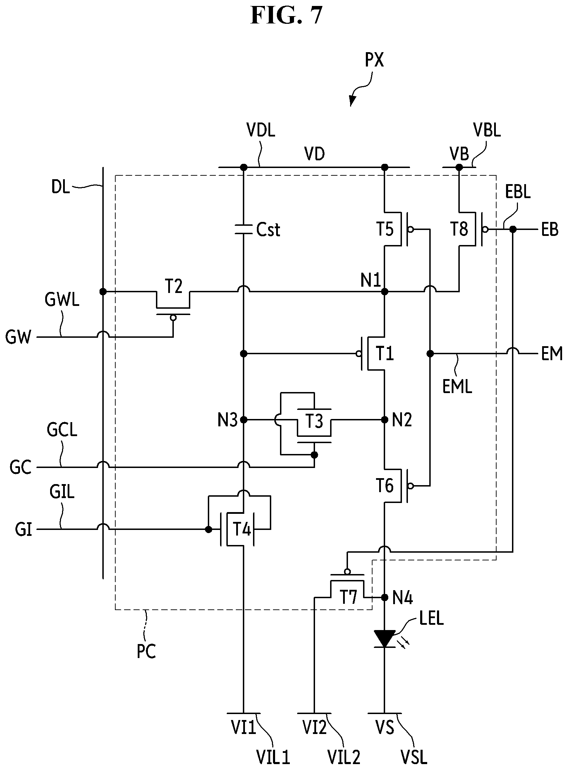

A gate timing control signal, an emission timing control signal, a gate clock signal, an emission clock signal, a gate start signal, an emission start signal, a high potential voltage and a low potential voltage from the timing controller may be supplied to the first gate driver GD1 and the first emission driver ED1 through the first control terminals C1 of the first circuit board CB1 and the first control pads C11 of the display panel 110. For example, the gate timing control signal, the gate clock signal, the gate start signal, the high potential voltage and the low potential voltage may be supplied to the first gate driver GD1, and the emission timing control signal, the emission clock signal, the emission start signal, the high potential voltage and the low potential voltage may be supplied to the first emission driver ED1. Power signals from the power supply unit may be supplied to the first gate driver GD1, the emission driver ED1, and the pixels PX through the first power terminals P1 of the first circuit board CB1 and the first power pads P11 of the display panel 110. The power signals may include, for example, a driving voltage VD (see FIG. 7), a common voltage VS (see FIG. 7), a first initialization voltage VI1 (see FIG. 7), a second initialization voltage VI2 (see FIG. 7), and a bias voltage VB (see FIG. 7). Data signals from the first data driving circuit DDC1 may be respectively supplied to the first data lines through the first data terminals D1 of the first circuit board CB1 and the first data pads D11 of the display panel 110.

Power signals from the power supply unit may be supplied to the pixels PX through the second power terminals P2 of the second circuit board CB2 and the second power pads P22 of the display panel 110. Data signals from the second data driving circuit DDC2 may be respectively supplied to the second data lines through the second data terminals D2 of the second circuit board CB2 and the second data pads D22 of the display panel 110.

Power signals from the power supply unit may be supplied to the pixels PX through the third power terminals P3 of the third circuit board CB3 and the third power pads P33 of the display panel 110. Data signals from the third data driving circuit DDC3 may be respectively supplied to the third data lines through the third data terminals D3 of the third circuit board CB3 and the third data pads D33 of the display panel 110.

Power signals from the power supply unit may be supplied to the pixels PX through the fourth power terminals P4 of the fourth circuit board CB4 and the fourth power pads P44 of the display panel 110. Data signals from the fourth data driving circuit DDC4 may be respectively supplied to the fourth data lines through the fourth data terminals D4 of the fourth circuit board CB4 and the fourth data pads D44 of the display panel 110.

A gate timing control signal, an emission timing control signal, a gate clock signal, an emission clock signal, a high potential voltage and a low potential voltage from the timing controller may be supplied to the second gate driver GD2 and the second emission driver ED2 through the second control terminals C2 of the fifth circuit board CB5 and the second control pads C22 of the display panel 110. For example, the gate timing control signal, the gate clock signal, the high potential voltage and the low potential voltage may be supplied to the second gate driver GD2, and the emission timing control signal, the emission clock signal, the high potential voltage and the low potential voltage may be supplied to the second emission driver ED2.

Power signals from the power supply unit may be supplied to the second gate driver GD2, the second emission driver ED2 and the pixels PX through the fifth power terminals P5 of the fifth circuit board CB5 and the fifth power pads P55 of the display panel 110. Data signals from the fifth data driving circuit DDC5 may be respectively supplied to the fifth data lines through the fifth data terminals D5 of the fifth circuit board CB5 and the fifth data pads D55 of the display panel 110. The high potential voltage may be greater than a driving voltage, and the low potential voltage may be smaller than a common voltage.

As illustrated in FIG. 1, a width W1 (hereinafter, referred to as a first group terminal width W1) of the first group terminal BP1 including the first terminals C1, P1 and D1 may be defined as a size in an arrangement direction (e.g., the first direction DR1) of the first terminals C1, P1 and D1. For example, the first group terminal width W1 may be defined as a distance between an outer side (hereinafter, referred to as a first outer side) of a first terminal (e.g., an outermost first control terminal C1 among the first control terminals C1) located at an edge among the first terminals C1, P1 and D1 of the first circuit board CB1 and an outer side (hereinafter, referred to as a second outer side) of a first terminal (e.g., an outermost first power terminal P1 among the first power terminals P1) located at the other edge among the first terminals C1, P1 and D1 of the first circuit board CB1. Here, the first outer side may be located close to a first side of the first circuit board CB1 which intersects a side (e.g., a lower side) of the display panel 110, and the second outer side may be located or arranged close to a second side of the first circuit board CB1 which intersects the side (e.g., the lower side) of the display panel 110. That is, the second side may face the first side.

Likewise, a width W2 (hereinafter, referred to as a second group terminal width W2) of the second group terminal BP2 including the second terminals P2 and D2 may be defined as a size in an arrangement direction (e.g., the first direction DR1) of the second terminals P2 and D2. A width W3 (hereinafter, referred to as a third group terminal width W3) of the third group terminal BP3 including the third terminals P3 and D3 may be defined as a size in an arrangement direction (e.g., the first direction DR1) of the third terminals P3 and D3. A width W4 (hereinafter, referred to as a fourth group terminal width W4) of the fourth group terminal BP4 including the fourth terminals P4 and D4 may be defined as a size in an arrangement direction (e.g., the first direction DR1) of the fourth terminals P4 and D4. A width W5 (hereinafter, referred to as a fifth group terminal width W5) of the fifth group terminal BP5 including the fifth terminals C2, P5 and D5 may be defined as a size in an arrangement direction (e.g., the first direction DR1) of the fifth terminals C2, P5 and D5.

At least two circuit boards may have different group terminal widths. For example, circuit boards excluding outermost circuit boards among the circuit boards may have a smaller group terminal width than the outermost circuit boards. Here, the outermost circuit boards may be defined as a first outermost circuit board and a second outermost circuit board, respectively, and a circuit board (or circuit boards) between the first outermost circuit board and the second outermost circuit board may be defined as a middle circuit board. In this case, a group terminal width of the middle circuit board may be smaller than a group terminal width of the first outermost circuit board (or the second outermost circuit board). The first outermost circuit board may be the first circuit board CB1, the second outermost circuit board may be the fifth circuit board CB5, and the middle circuit board may be at least one of the second through fourth circuit boards CB2 through CB4. For example, as illustrated in FIG. 1, the second group terminal width W2 of the second circuit board CB2 may be smaller than the first group terminal width W1 of the first circuit board CB1.

The group terminal width of the first outermost circuit board and the group terminal width of the second outermost circuit board may be equal. For example, the first group terminal width W1 of the first circuit board CB1 and the fifth group terminal width W5 of the fifth circuit board CB5 may be equal.

Group terminal widths of middle circuit boards may be equal. For example, the second group terminal width W2 of the second circuit board CB2, the third group terminal width W3 of the third circuit board CB3, and the fourth group terminal width W4 of the fourth circuit board CB4 may be equal to each other.

As illustrated in FIG. 2, a width W11 (hereinafter, referred to as a first group pad width W11) of a first group pad PD1 including the first pads C11, P11 and D11 may be defined as a size in an arrangement direction (e.g., the first direction DR1) of the first pads C11, P11 and D11. For example, the first group pad width W11 may be defined as a distance between an outer side (hereinafter, referred to as a left side) of a first pad (e.g., an outermost first control pad C11 among the first control pads C11) located at an edge among the first pads C11, P11 and D11 and an outer side (hereinafter, referred to as a right side) of a first pad (e.g., an outermost first power pad P11 among the first power pads P11) located at the other edge among the first pads C11, P11 and D11. Here, the left side may be located close to the first side of the first circuit board CB1 which intersects a side (e.g., the lower side) of the display panel 110, and the right side may be located close to the second side of the first circuit board CB1 which intersects the side (e.g., the lower side) of the display panel 110.

Likewise, a width W22 (hereinafter, referred to as a second group pad width W22) of a second group pad PD2 including the second pads P22 and D22 may be defined as a size in an arrangement direction (e.g., the first direction DR1) of the second pads P22 and D22. A width W33 (hereinafter, referred to as a third group pad width W33) of a third group pad PD3 including the third pads P33 and D33 may be defined as a size in an arrangement direction (e.g., the first direction DR1) of the third pads P33 and D33. A width W44 (hereinafter, referred to as a fourth group pad width W44) of a fourth group pad PD4 including the fourth pads P44 and D44 may be defined as a size in an arrangement direction (e.g., the first direction DR1) of the fourth pads P44 and D44. A width W55 (hereinafter, referred to as a fifth group pad width W55) of a fifth group pad PD5 including the fifth pads C22, P55 and D55 may be defined as a size in an arrangement direction (e.g., the first direction DR1) of the fifth pads C22, P55 and D55.

At least two group pads may have different group pad widths. For example, group pads excluding outermost group pads among the pads may have a smaller group pad width than the outermost group pads. Here, the outermost group pads may be defined as a first outermost group pad and a second outermost group pad, respectively, and pads between the first outermost group pad and the second outermost group pad may be defined as a middle group pad. In this case, a group pad width of the middle group pad may be smaller than a group pad width of the first outermost group pad (or the second outermost group pad). The first outermost group pad may be the first group pad PD1, the second outermost group pad may be the fifth group pad PD5, and the middle group pad may be at least one of the second through fourth group pads PD2 through PD4. For example, as illustrated in FIG. 2, the second group pad width W22 of the second group pad PD2 may be smaller than the first group pad width W11 of the first group pad PD1.

The pad width of the first outermost group pad and the pad width of the second outermost group pad may be equal. For example, the first group pad width W11 of the first group pad PD1 and the fifth group pad width W55 of the fifth group pad PD5 may be equal.

Group pad widths of middle group pads may be equal. For example, the second group pad width W22 of the second group pad PD2, the third group pad width W33 of the third group pad PD3, and the fourth group pad width W44 of the fourth group pad PD4 may be equal to each other.

A group terminal and a group pad corresponding to each other may have the same width. For example, the first group terminal BP1 of the first circuit board CB1 and the first group pad PD1 overlapped by the first circuit board CB1 may have the same width. In other words, the first group terminal width W1 and the first group pad width W11 may be equal. Likewise, the second group terminal width W2 may be equal to the second group pad width W22, the third group terminal width W3 may be equal to the third group pad width W33, the fourth group terminal width W4 may be equal to the fourth group pad width W44, and the fifth group terminal width W5 may be equal to the fifth group pad width W55.

A group terminal and a group pad corresponding to each other may have different widths. For example, the first group terminal BP1 of the first circuit board CB1 and the first group pad PD1 overlapped by the first circuit board CB1 may have different widths. The first group terminal width W1 may be greater than the first group pad width W11. Likewise, the second group terminal width W2 may be greater than the second group pad width W22, the third group terminal width W3 may be greater than the third group pad width W33, the fourth group terminal width W4 may be greater than the fourth group pad width W44, and the fifth group terminal width W5 may be greater than the fifth group pad width W55. In other words, in the case of a group terminal width and a group pad width corresponding to each other, the group terminal width may be greater than the group pad width.

At least one alignment key may be located in the non-display area NDA. For example, a first alignment key AK1, a second alignment key AK2, a third alignment key AK3, and a fourth alignment key AK4 may be located in the non-display area NDA. For example, the first alignment key AK1 may be located between the first circuit board CB1 and the second circuit board CB2 adjacent to each other in the first direction DR1 in the non-display area NDA. The second alignment key AK2 may be located between the second circuit board CB2 and the third circuit board CB3 adjacent to each other in the first direction DR1 in the non-display area NDA. The third alignment key AK3 may be located between the third circuit board CB3 and the fourth circuit board CB4 adjacent to each other in the first direction DR1 in the non-display area NDA. The fourth alignment key AK4 may be located between the fourth circuit board CB4 and the fifth circuit board CB5 adjacent to each other in the first direction DR1 in the non-display area NDA. The first through fourth alignment keys AK1 through AK4 may be marks for alignment between the circuit boards CB1 through CB5 and the display panel 110. The circuit boards CB1 through CB5 may be aligned with the display panel 110 through the first through fourth alignment keys AK1 through AK4. In addition, whether the circuit boards CB1 through CB5 and the display panel 110 are accurately aligned with each other can be checked through the first through fourth alignment keys AK1 through AK4. Each of the first through fourth alignment keys AK1 through AK4 may have, for example, a cross shape.

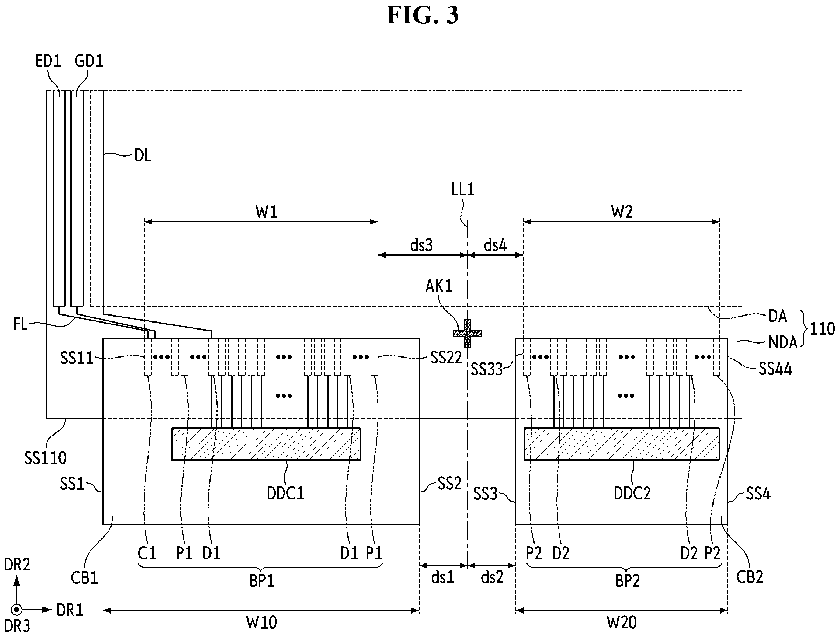

FIG. 3 is an enlarged view of the part A1 of FIG. 1.

As illustrated in FIG. 3, the first circuit board CB1 and the second circuit board CB2 having different group terminal widths may be aligned based on the first alignment key AK1.

Among sides of the first circuit board CB1, sides which are located opposite each other in the first direction DR1 and intersect (or overlap) a side SS110 (e.g., the lower side) of the display panel 110 may be defined as a first side SS1 and a second side SS2 of the first circuit board CB1, respectively. In this case, the second side SS2 of the first circuit board CB1 may be located close to the first alignment key AK1.

Among sides of the first circuit board CB1, sides which are located opposite each other in the first direction DR1 and intersect (or overlap) the side SS110 (e.g., the lower side) of the display panel 110 may be defined as a third side SS3 and a fourth side SS4 of the second circuit board CB2, respectively. In this case, the third side SS3 of the second circuit board CB2 may be located close to the first alignment key AK1.

Facing sides (e.g., sides facing each other in the first direction DR1) of the first circuit board CB1 and the second circuit board CB2, which have different group terminal widths and are located adjacent to each other, may be at the same distance from the first alignment key AK1 in the first direction DR1. The same distance refers to a length of each side from a center of the first alignment key AK1 in the first direction DR1. In other words, sides of circuit boards located close to (or facing) each other with the first alignment key AK1 interposed between them may be at the same distance from the first alignment key AK1. For example, a distance ds1 between the first alignment key AK1 and the second side SS2 of the first circuit board CB1 may be equal to a distance ds2 between the first alignment key AK1 and the third side SS3 of the second circuit board CB2. In other words, when an imaginary line passing through the center of the first alignment key AK1 and extending parallel to the second side SS2 is defined as an alignment line LL1, a distance ds1 (e.g., a distance in the first direction DR1) between the alignment line LL1 and the second side SS2 may be equal to a distance ds2 (e.g., a distance in the first direction DR1) between the alignment line LL1 and the third side SS3.

In the first circuit board CB1 and the second circuit board CB2 having different group terminal widths and located adjacent to each other, a distance ds3 between any one of facing sides of a terminal of the first circuit board CB1 and a terminal of the second circuit board CB2 and the first alignment key AK1 may be different from a distance ds4 between the other one of the facing sides and the first alignment key AK1. For example, among the first terminals C1, P1 and D1 of the first circuit board CB1, a terminal located at an outermost position of the first circuit board CB1 to be close to the first alignment key AK1 may be defined as a first outermost terminal of the first circuit board CB1. In addition, among the second terminals P2 and D2 of the second circuit board CB2 having a different group terminal width from the first circuit board CB1, a terminal located at an outermost position of the second circuit board CB2 to be close to the first alignment key AK1 may be defined as a second outermost terminal of the second circuit board CB2. In this case, the first outermost terminal and the second outermost terminal may be located at different distances from the first alignment key AK1. For example, a distance ds3 between the first alignment key AK1 and the first outermost terminal of the first circuit board CB1 may be different from a distance ds4 between the first alignment key AK1 and the second outermost terminal of the second circuit board CB2. In other words, a distance ds3 (e.g., a distance in the first direction DR1) between the alignment line LL1 and the first outermost terminal (or an outer side SS22 of the first outermost terminal) may be different from a distance ds4 (e.g., a distance in the first direction DR1) between the alignment line LL1 and the second outermost terminal (or an outer side SS33 of the second outermost terminal). For example, the distance ds3 between the first outermost terminal of the first circuit board CB1 having a relatively greater group terminal width and the first alignment key AK1 may be greater than the distance ds4 between the second outermost terminal of the second circuit board CB2 having a relatively smaller width and the first alignment key AK1.

Likewise, facing sides (e.g., sides facing each other in the first direction DR1) of the fourth circuit board CB4 and the fifth circuit board CB5, which have different group terminal widths and are located adjacent to each other, may be at the same distance from the fourth alignment key AK4 between them in the first direction DR1.

Likewise, a distance between the fourth alignment key AK4 and an outermost terminal of the fifth circuit board CB5 may be greater than a distance between the fourth alignment key AK4 and an outermost terminal of the fourth circuit board CB4.

The above-described first group terminal width W1 of the first circuit board CB1 may be defined as a distance between an outer side SS11 of a first terminal (e.g., a first control terminal C1) located at an outermost position on one side of the first circuit board CB1 and an outer side SS22 of a first terminal (e.g., a first power terminal P1) located at an outermost position on the other side of the first circuit board CB1.

Likewise, the above-described second group terminal width W2 of the second circuit board CB2 may be defined as a distance between an outer side SS33 of a second terminal (e.g., a second power terminal P2) located at an outermost position on one side of the second circuit board CB2 and an outer side SS44 of a second terminal (e.g., a second power terminal P2) located at an outermost position on the other side of the second circuit board CB2.

At least two of the circuit boards CB1 through CB5 may have different widths. For example, a circuit board having a relatively greater group terminal width may have a greater width. In other words, a width of an outermost circuit board may be greater than a width of a middle circuit board. For example, a width W10 of the first circuit board CB1 may be greater than a width W20 of the second circuit board CB2. Here, a width of a circuit board may be a size in the first direction DR1. For example, as illustrated in FIG. 3, the width W10 of the first circuit board CB1 may be a distance between the first side SS1 of the first circuit board CB1 and the second side SS2 of the first circuit board CB1, and the width W20 of the second circuit board CB2 may be a distance between the third side SS3 of the second circuit board CB2 and the fourth side SS4 of the second circuit board CB2.

At least two of the middle circuit boards may have the same width. For example, the width W20 of the second circuit board CB2, a width W30 of the third circuit board CB3, and a width W40 of the fourth circuit board CB4 may be the same.

Widths of the data driving circuits DDC1 through DDC5 may be the same regardless of the widths of the circuit boards. For example, a width of the first data driving circuit DDC1, a width of the second data driving circuit DDC2, a width of the third data driving circuit DDC3, a width of the fourth data driving circuit DDC4, and a width of the fifth data driving circuit DDC5 may be equal to each other. Here, a width of a data driving circuit may be a size in the first direction DR1.

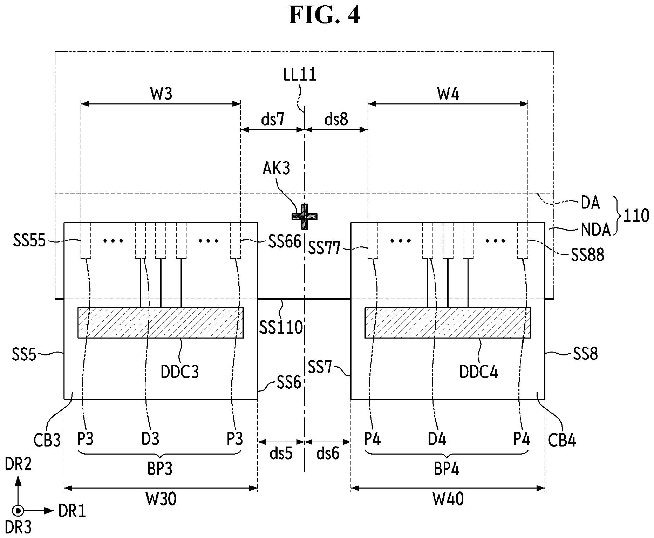

FIG. 4 is an enlarged view of the part A2 of FIG. 1.

As illustrated in FIG. 4, the third circuit board CB3 and the fourth circuit board CB4 having the same group terminal width may be aligned based on the third alignment key AK3.

Among sides of the third circuit board CB3, sides which are located opposite each other in the first direction DR1 and intersect (or overlap) the side SS110 (e.g., the lower side) of the display panel 110 may be defined as a first side SS5 and a second side SS6 of the third circuit board CB3, respectively. In this case, the second side SS6 of the third circuit board CB3 may be located close to the third alignment key AK3.

Among sides of the fourth circuit board CB4, sides which are arranged opposite each other in the first direction DR1 and intersect (or overlap) the side SS110 (e.g., the lower side) of the display panel 110 may be defined as a third side SS7 and a fourth side SS8 of the fourth circuit board CB4, respectively. In this case, the third side SS7 of the fourth circuit board CB4 may be located close to the third alignment key AK3.

Facing sides (e.g., sides facing each other in the first direction DR1) of the third circuit board CB3 and the fourth circuit board CB4, which have the same group terminal width and are located adjacent to each other, may be at the same distance from the third alignment key AK3. In other words, sides of circuit boards located close to (or facing) each other with the third alignment key AK3 interposed between them may be at the same distance from the third alignment key AK3. For example, a distance ds5 between the third alignment key AK3 and the second side SS6 of the third circuit board CB3 may be equal to a distance ds6 between the third alignment key AK3 and the third side SS7 of the fourth circuit board CB4. In other words, when an imaginary line passing through a center of the third alignment key AK3 and extending parallel to the second side SS6 is defined as an alignment line LL11, a distance ds5 (e.g., a distance in the first direction DR1) between the alignment line LL11 and the second side SS6 may be equal to a distance ds6 (e.g., a distance in the first direction DR1) between the alignment line LL11 and the third side SS7. The distances ds1, ds2, ds5, and ds6 described above may all be the same or different from each other.

In addition, among the third terminals P3 and D3 of the third circuit board CB3, a terminal located at an outermost position of the third circuit board CB3 to be close to the third alignment key AK3 may be defined as a first outermost terminal of the third circuit board CB3. Among the fourth terminals P4 and D4 of the fourth circuit board CB4 having the same group terminal width as the third circuit board CB3, a terminal located at an outermost position of the fourth circuit board CB4 to be close to the third alignment key AK3 may be defined as a second outermost terminal of the fourth circuit board CB4. In this case, the first outermost terminal and the second outermost terminal may be arranged at the same distance from the third alignment key AK3. For example, a distance ds7 between the third alignment key AK3 and the first outermost terminal of the third circuit board CB3 may be equal to a distance ds8 between the third alignment key AK3 and the second outermost terminal of the fourth circuit board CB4. In other words, a distance ds7 (e.g., a distance in the first direction DR1) between the alignment line LL11 and the first outermost terminal (or an outer side SS66 of the first outermost terminal) may be equal to a distance ds8 (e.g., a distance in the first direction DR1) between the alignment line LL11 and the second outermost terminal (or an outer side SS77 of the second outermost terminal). For example, the distance ds7 between the first outermost terminal of the third circuit board CB3 and the third alignment key AK3 may be equal to the distance ds8 between the second outermost terminal of the fourth circuit board CB4 and the third alignment key AK3.

Likewise, facing sides (e.g., sides facing each other in the first direction DR1) of the second circuit board CB2 and the third circuit board CB3, which have the same group terminal width and are located adjacent to each other, may be at the same distance from the second alignment key AK2 between them.

Likewise, a distance between the second alignment key AK2 and an outermost terminal of the second circuit board CB2 may be equal to a distance between the second alignment key AK2 and an outermost terminal of the third circuit board CB3.

The above-described third group terminal width W3 of the third circuit board CB3 may be defined as a distance between an outer side SS55 of a third terminal (e.g., a third power terminal P3 at a left end) located at an outermost position on one side of the third circuit board CB3 and an outer side SS66 of a third terminal (e.g., a third power terminal P3 at a right end) located at an outermost position on the other side of the third circuit board CB3.

Likewise, the above-described fourth group terminal width W4 of the fourth circuit board CB4 may be defined as a distance between an outer side SS77 of a fourth terminal (e.g., a fourth power terminal P4 at a left end) located at an outermost position on one side of the fourth circuit board CB4 and an outer side SS88 of a fourth terminal (e.g., a fourth power terminal P4 at a right end) located at an outermost position on the other side of the fourth circuit board CB4.

At least two of the circuit boards may have the same width. For example, circuit boards having the same group terminal width may have the same width. For example, the width of the first circuit board CB1 and the width of the fifth circuit board CB5 may be equal to each other. In addition, the width of the second circuit board CB2, the width of the third circuit board CB3, and the width of the fourth circuit board CB4 may be equal to each other. Here, a width of a circuit board may be a size in a third direction. As in the example illustrated in FIG. 4, a distance between the first side SS5 of the third circuit board CB3 and the second side SS6 of the third circuit board CB3 may be equal to a distance between the third side SS7 of the fourth circuit board CB4 and the fourth side SS8 of the fourth circuit board CB4.

A circuit board having a relatively greater group terminal width may have a greater width. For example, the width of the first circuit board CB1 may be greater than the width of the second circuit board CB2. Here, a width of a circuit board may be a size in the first direction DR1. For example, as in the example illustrated in FIG. 3, the width of the first circuit board CB1 may be the distance between the first side SS1 of the first circuit board CB1 and the second side SS2 of the first circuit board CB1, and the width of the second circuit board CB2 may be the distance between the third side SS3 of the second circuit board CB2 and the fourth side SS4 of the second circuit board CB2.

A width W2 of a group terminal of a middle circuit board (e.g., CB2) is smaller than a width W1 of a group terminal of an outermost circuit board (e.g., CB1). Therefore, a distance (e.g., the sum of ds3 and ds4 in FIG. 3) between group terminals of adjacent circuit boards may increase, which, in turn, increases a distance between group pads corresponding to the group terminals (e.g., a distance between a first pad P11 at a right edge and a second pad P22 at a left edge in FIG. 2). Therefore, a distance between the group pads PD1 through PD5 may increase, thereby securing a sufficient margin area for placing the first alignment key AK1. Accordingly, alignment between the circuit boards CB1 through CB5 can be easily checked, and thus misalignment between the circuit boards CB1 through CB5 can be minimized.

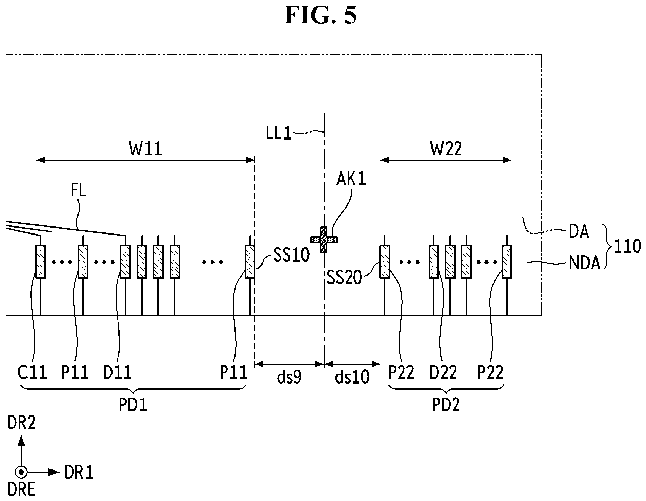

FIG. 5 is an enlarged view of the part A3 of FIG. 2.

An outermost group pad and a middle group pad adjacent to the outermost group pad may be at different distances from an alignment key between them in the first direction DR1. For example, as illustrated in FIG. 5, a distance ds10 between the alignment line LL1 passing through the center of the first alignment key AK1 and the second group pad PD2 in the first direction DR1 may be smaller than a distance ds9 between the alignment line LL1 and the first group pad PD1 in the first direction DR1. For example, a first power pad P11 of the first group pad PD1 and a second power pad P22 of the second group pad PD2 face each other with the first alignment key AK1 between them. Therefore, a distance ds10 between the alignment line LL1 of the first alignment key AK1 and an outer side SS20 of the second power pad P22 in the first direction DR1 may be smaller than a distance ds9 between the alignment line LL1 and an outer side SS10 of the first power pad P11 in the first direction DR1. Here, the outer side SS10 of the first power pad P11 and the outer side SS20 of the second power pad P22 may face each other in the first direction DR1 with the first alignment key AK1 interposed between them.

Likewise, a distance between an alignment line passing through a center of the fourth alignment key AK4 and the fourth group pad PD4 in the first direction DR1 may be smaller than a distance between the alignment line passing through the center of the fourth alignment key AK4 and the fifth group pad PD5 in the first direction DR1.

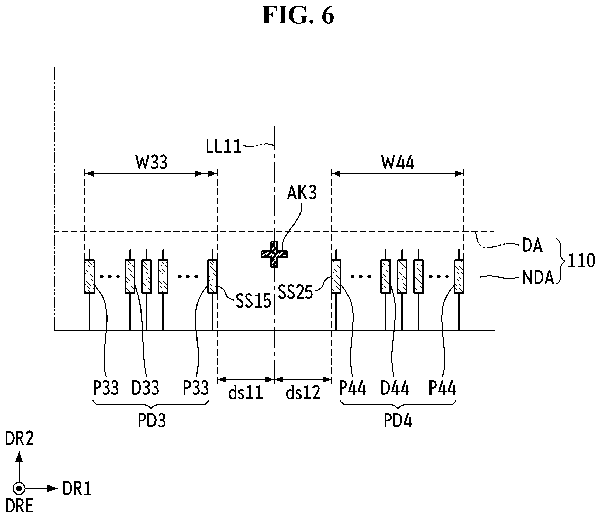

FIG. 6 is an enlarged view of the part A4 of FIG. 2.

Middle group pads may be at the same distance from an alignment key between them in the first direction DR1. For example, as illustrated in FIG. 6, a distance ds11 between the alignment line LL11 passing through the center of the third alignment key AK3 and the third group pad PD3 in the first direction DR1 may be equal to a distance ds12 between the alignment line LL11 and the fourth group pad PD4 in the first direction DR1. For example, a third power pad P33 of the third group pad PD3 and a fourth power pad P44 of the fourth group pad PD4 may face each other with the third alignment key AK3 between them. Therefore, a distance ds11 between the alignment line LL11 of the third alignment key AK3 and an outer side SS15 of the third power pad P33 in the first direction DR1 may be equal to a distance ds12 between the alignment line LL11 and an outer side SS25 of the fourth power pad P44 in the first direction DR1. Here, the outer side SS15 of the third power pad P33 and the outer side SS25 of the fourth power pad P44 may face each other in the first direction DR1 with the third alignment key AK3 interposed between them.

Likewise, a distance between an alignment line passing through a center of the second alignment key AK2 and the second group pad PD2 in the first direction DR1 may be equal to a distance between the alignment line passing through the center of the second alignment key AK2 and the third group pad PD3 in the first direction DR1.

FIG. 7 is a circuit diagram of a pixel PX of the display device 100. For example, FIG. 7 may be a circuit diagram of a pixel PX of FIG. 1. Although FIG. 7 illustrates various components in a pixel PX, as a person having ordinary skill in the art would appreciate, the components are not limited thereto, and the pixel PX may include additional components or fewer components.

As illustrated in FIG. 7, the pixel PX may be connected to a first gate line GWL, a second gate line GCL, a third gate line GIL, a fourth gate line EBL, an emission control line EML, a data line DL, a driving voltage line VDL, a common voltage line VSL, a first initialization voltage line VIL1, a second initialization voltage line VIL2, and a bias voltage line VBL.

The pixel PX may include a pixel circuit PC and a light emitting element LEL. The pixel circuit PC may include a first transistor T1, a second transistor T2, a third transistor T3, a fourth transistor T4, a fifth transistor T5, a sixth transistor T6, a seventh transistor T7, an eighth transistor T8, and a capacitor Cst.

The first transistor T1 may include a gate electrode, a source electrode, and a drain electrode. The first transistor T1 may control a source-drain current (hereinafter, referred to as a driving current) according to a data voltage applied to the gate electrode. The driving current (e.g., Isd) flowing through a channel region of the first transistor T1 may be proportional to the square of a difference between a voltage Vgs between the source electrode and the gate electrode of the first transistor T1 and a threshold voltage Vth (Isd = k×(Vgs - Vth)²), where k is a proportional coefficient determined by the structure and physical characteristics of the first transistor T1, Vgs is a source-gate voltage of the first transistor T1, and Vth is a threshold voltage of the first transistor T1.

The light emitting element LEL may emit light in response to the driving current Isd received. The amount of light emitted from the light emitting element LEL or the luminance of the light emitting element LEL may be proportional to the magnitude of the driving current Isd.

The light emitting element LEL may be an organic light emitting diode including a first electrode, a second electrode, and an organic light emitting layer located between the first electrode and the second electrode. For another example, the light emitting element LEL may be an inorganic light emitting element including a first electrode, a second electrode, and an inorganic semiconductor located between the first electrode and the second electrode. For another example, the light emitting element LEL may be a quantum dot light emitting element including a first electrode, a second electrode, and a quantum dot light emitting layer located between the first electrode and the second electrode. For another example, the light emitting element LEL may be a micro-light emitting diode.

The first electrode of the light emitting element LEL may be electrically connected to a fourth node N4. The first electrode of the light emitting element LEL may be connected to a drain electrode of the sixth transistor T6 and a source electrode of the seventh transistor T7 through the fourth node N4. The second electrode of the light emitting element LEL may be connected to a second driving voltage line VSL. The second electrode of the light emitting element LEL may receive a second driving voltage VS (e.g., a low potential voltage) from the common voltage line VSL.

The second transistor T2 may be turned on by a first gate signal GW of the first gate line GWL to electrically connect the data line DL and a first node N1 which is the source electrode of the first transistor T1. The second transistor T2 turned on based on the first gate signal GW may supply a data voltage to the first node N1. The second transistor T2 may have a gate electrode electrically connected to the first gate line GWL, a source electrode electrically connected to the data line DL, and a drain electrode electrically connected to the first node N1.

The third transistor T3 may be turned on by a second gate signal GC of the second gate line GCL to electrically connect a second node N2 which is the drain electrode of the first transistor T1 and a third node N3 which is the gate electrode of the first transistor T1. The third transistor T3 may be connected between the third node N3 and the second node N2. For example, the third transistor T3 may have a gate electrode electrically connected to the second gate line GCL, a source electrode electrically connected to the third node N3, and a drain electrode electrically connected to the second node N2. The third transistor T3 may be turned on by the second gate signal GC of the second gate line GCL to electrically connect the second node N2 which is the drain electrode of the first transistor T1 and the third node N3 which is the gate electrode of the first transistor T1. The third transistor T3 may be a double-gate transistor having two gate electrodes (e.g., a gate electrode and a counter gate electrode). The gate electrode and the counter gate electrode may be located on different layers to face each other.

The fourth transistor T4 may be turned on by a third gate signal GI of the third gate line GIL to electrically connect the third node N3, which is the gate electrode of the first transistor T1, and the first initialization voltage line VIL1. The fourth transistor T4 may be connected in series between the third node N3 and the first initialization voltage line VIL1. For example, the fourth transistor T4 may have a gate electrode electrically connected to the third gate line GIL, a source electrode electrically connected to the third node N3, and a drain electrode electrically connected to the first initialization voltage line VIL1. The fourth transistor T4 may be a double-gate transistor. The first initialization voltage line VIL1 may transmit a first initialization voltage VI1.

The fifth transistor T5 may be turned on by an emission control signal EM of the emission control line EML to electrically connect the driving voltage line VDL and the first node N1 which is the source electrode of the first transistor T1. The fifth transistor T5 may have a gate electrode electrically connected to the emission control line EML, a source electrode electrically connected to the driving voltage line VDL, and a drain electrode electrically connected to the first node N1.

The sixth transistor T6 may be turned on by the emission control signal EM of the emission control line EML to electrically connect the second node N2 which is the drain electrode of the first transistor T1 and the fourth node N4 which is the first electrode of the light emitting element LEL. The sixth transistor T6 may have a gate electrode electrically connected to the emission control line EML, a source electrode electrically connected to the second node N2, and the drain electrode electrically connected to the fourth node N4.

When the fifth transistor T5, the first transistor T1, and the sixth transistor T6 are all turned on, a driving current may be supplied to the light emitting element LEL.

The seventh transistor T7 may be turned on by a fourth gate signal EB of the fourth gate line EBL to electrically connect the fourth node N4 which is the first electrode of the light emitting element LEL and the second initialization voltage line VIL2. The seventh transistor T7 turned on based on the fourth gate signal EB may discharge the first electrode of the light emitting element LEL to a second initialization voltage VI2. The seventh transistor T7 may have a gate electrode electrically connected to the fourth gate line EBL, the source electrode electrically connected to the fourth node N4, and a drain electrode electrically connected to the second initialization voltage line VIL2. The second initialization voltage line VIL2 may transmit the second initialization voltage VI2.

The eighth transistor T8 may be turned on by the fourth gate signal EB of the fourth gate line EBL to electrically connect the bias voltage line VBL and the first node N1 which is the source electrode of the first transistor T1. The eighth transistor T8 turned on based on the fourth gate signal EB may supply a bias voltage VB to the first node N1. The eighth transistor T8 may improve hysteresis of the first transistor T1 by supplying the bias voltage VB to the source electrode of the first transistor T1. The eighth transistor T8 may have a gate electrode electrically connected to the fourth gate line EBL, a source electrode electrically connected to the bias voltage line VBL, and a drain electrode electrically connected to the first node N1.

Each of the first transistor T1, the second transistor T2, the fifth transistor T5, the sixth transistor T6, the seventh transistor T7, and the eighth transistor T8 may include a silicon-based active layer. For example, each of the first transistor T1, the second transistor T2, the fifth transistor T5, the sixth transistor T6, the seventh transistor T7, and the eighth transistor T8 may be a p-type transistor including an active layer made of low temperature polycrystalline silicon (LTPS). The active layer made of low temperature polycrystalline silicon may have high electron mobility and excellent turn-on characteristics. Therefore, the display device 100 including transistors with excellent turn-on characteristics can stably and efficiently drive the pixels PX. Each of the first transistor T1, the second transistor T2, the fifth transistor T5, the sixth transistor T6, the seventh transistor T7, and the eighth transistor T8 may output a current, which flows into the source electrode, to the drain electrode based on a gate-low voltage applied to the gate electrode.

Each of the third transistor T3 and the fourth transistor T4 may be an n-type transistor including an oxide-based active layer. A transistor including an oxide-based active layer may have a coplanar structure in which a gate electrode located at the top. The transistor including the oxide-based active layer may output a current, which flows into a drain electrode, to a source electrode based on a gate-high voltage applied to a gate electrode.

The capacitor Cst may be electrically connected between the third node N3, which is the gate electrode of the first transistor T1, and the driving voltage line VDL. For example, a first electrode of the capacitor Cst may be electrically connected to the third node N3, and a second electrode of the capacitor Cst may be electrically connected to the driving voltage line VDL. Accordingly, a potential difference between the driving voltage line VDL and the gate electrode of the first transistor T1 can be maintained.

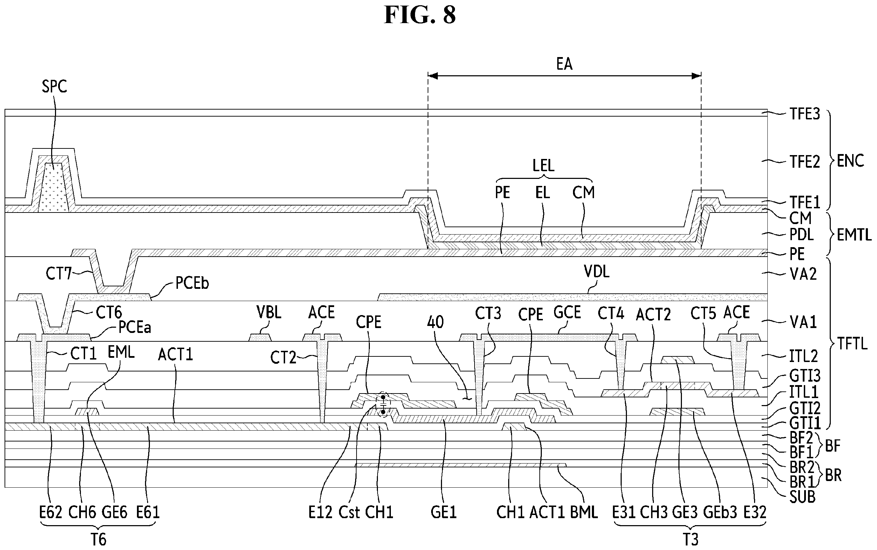

FIG. 8 is a cross-sectional view of the display device 100.

As illustrated in FIG. 8, the display device 100 may include a substrate SUB, a barrier layer BR, a thin-film transistor layer TFTL, a light emitting element layer EMTL, and an encapsulation layer ENC. The barrier layer BR, the thin-film transistor layer TFTL, the light emitting element layer EMTL, and the encapsulation layer ENC may be sequentially located on the substrate SUB along a third direction DR3.

The substrate SUB may be a rigid substrate or a flexible substrate that can be bent, folded, or rolled. The substrate SUB may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terepthalate (PET), polyphenylene sulfide (PPS), polyallylate, polyimide (PI), polycarbonate (PC), cellulose triacetate (CAT), cellulose acetate propionate (CAP), or a combination thereof. Alternatively, the substrate SUB may include a metal material.

As illustrated in FIG. 8, the barrier layer BR may be located on the substrate SUB. The barrier layer BR may be arranged on the entire surface of the substrate SUB. The barrier layer BR may be a layer for protecting transistors T1 through T8 of the thin-film transistor layer TFTL and a light emitting layer EL of the light emitting element layer EMTL from moisture introduced through the substrate SUB which is vulnerable to moisture penetration.

The barrier layer BR may be composed of a plurality of inorganic layers stacked alternately. For example, the barrier layer BR may be a multilayer (e.g., a first barrier layer BR1 and a second barrier layer BR2) in which one or more inorganic layers selected from a silicon nitride layer, a silicon oxynitride layer, a silicon oxide layer, a titanium oxide layer, and an aluminum oxide layer are alternately stacked.

As illustrated in FIG. 8, a first pattern layer may be located on the barrier layer BR. For example, a light blocking layer BML may be located on the barrier layer BR. The light blocking layer BML may be located on the barrier layer BR to cover an overlap region (e.g., a first channel region CH1) between a first gate electrode GE1 and a first active layer ACT1. In other words, the light blocking layer BML may be located on the barrier layer BR to overlap the channel region CH1 of a first transistor T1 which is a driving transistor.

The light blocking layer BML may be made of, for example, a metal material such as chromium (Cr) or molybdenum (Mo) or may be made of black ink or black dye. When the light blocking layer BML is made of a metal material, it may receive static power. Accordingly, the light blocking layer BML may not float electrically, and the electrical characteristics of a transistor (e.g., the first transistor T1) on the light blocking layer BML may be stabilized.

As illustrated in FIG. 8, a buffer layer BF may be located on the light blocking layer BML. The buffer layer BF may be arranged on the entire surface of the substrate SUB including the barrier layer BR. The buffer layer BF may be a layer for protecting the transistors T1 through T8 of the thin-film transistor layer TFTL and the light emitting layer EL of the light emitting element layer EMTL from moisture introduced through the substrate SUB which is vulnerable to moisture penetration.

The buffer layer BF may be composed of a plurality of inorganic layers stacked alternately. For example, the buffer layer BF may be a multilayer (e.g., a first buffer layer BF1 and a second buffer layer BF2) in which one or more inorganic layers selected from a silicon nitride layer, a silicon oxynitride layer, a silicon oxide layer, a titanium oxide layer, and an aluminum oxide layer are alternately stacked.

A second pattern layer may be located on the buffer layer BF. For example, the first active layer ACT1 may be located on the buffer layer BF. As illustrated in FIG. 8, the first active layer ACT1 may include the first channel region CH1 of the first transistor T1, a second electrode E12 of the first transistor T1, the first channel region CH1 of the first transistor T1, a first electrode E61 of a sixth transistor T6, a second electrode E62 of the sixth transistor T6, and a sixth channel region CH6 of the sixth transistor T6.

The first active layer ACT1 may be an active layer made of low temperature polycrystalline silicon (LTPS).

A first gate insulating layer GTI1 may be located on the second pattern layer. For example, as illustrated in FIG. 8, the first gate insulating layer GTI1 may be located on the first active layer ACT1. Here, the first gate insulating layer GTI1 may be aranged on the entire surface of the substrate SUB including the first active layer ACT1.

The first gate insulating layer GTI1 may include at least one of tetraethylorthosilicate (TEOS), silicon nitride (SiNₓ), or silicon oxide (SiO₂). For example, the first gate insulating layer GTI1 may have a double-layer structure in which a silicon nitride layer with a thickness of 40 nm and a tetraethylorthosilicate layer with a thickness of 80 nm are sequentially stacked.

A third pattern layer may be located on the first gate insulating layer GTI1. For example, a second gate electrode GE2, the first gate electrode GE1, an eighth gate electrode GE8, an emission control line EML, a fifth gate electrode GE5, and a sixth gate electrode GE6 may be located on the first gate insulating layer GTI1.

FIG. 8 shows an example in which the first gate electrode GE1, the sixth gate electrode GE6, and the emission control line EML are located on the first gate insulating layer GTI1. The first gate electrode GE1 may be located on the first gate insulating layer GTI1 to overlap the first channel region CH1 of the first active layer ACT1. The sixth gate electrode GE6 of the emission control line EML may be located on the first gate insulating layer GTI1 to overlap the sixth channel region CH6 of the first active layer ACT1.

The third pattern layer may include at least one of molybdenum (Mo), copper (Cu), aluminum and titanium (Ti), or may be a single layer or a multilayer. For example, the first gate electrode GE1 may be a triple layer including a titanium layer, an aluminum layer, and a titanium layer sequentially located on the first gate insulating layer GTI1 along the third direction DR3.

A second gate insulating layer GTI2 may be located on the third pattern layer. For example, as illustrated in FIG. 8, the second gate insulating layer GTI2 may be located on the first gate electrode GE1, the sixth gate electrode GE6, and the emission control line EML. Here, the second gate insulating layer GTI2 may be arranged on the entire surface of the substrate SUB including the first gate electrode GE1, the sixth gate electrode GE6, and the emission control line EML.

The second gate insulating layer GTI2 may include the same material and structure as the first gate insulating layer GTI1 described above.

A fourth pattern layer may be located on the second gate insulating layer GTI2. For example, a fourth counter gate electrode GEb4, a third counter gate electrode GEb3, and a capacitor electrode CPE may be located on the second gate insulating layer GTI2. FIG. 8 shows an example in which the capacitor electrode CPE and the third counter gate electrode GEb3 are located on the second gate insulating layer GTI2. The capacitor electrode CPE may be located on the second gate insulating layer GTI2 to overlap the first gate electrode GE1. A capacitor Cst may be formed between the capacitor electrode CPE and the first gate electrode GE1.

The fourth pattern layer may have the same material or structure as the third pattern layer described above.

A first interlayer insulating layer ITL1 may be located on the fourth pattern layer. For example, as illustrated in FIG. 8, the first interlayer insulating layer ITL1 may be located on the capacitor electrode CPE and the third counter gate electrode GEb3. Here, the first interlayer insulating layer ITL1 may be located on the entire surface of the substrate SUB including the capacitor electrode CPE and the third counter gate electrode GEb3.

The first interlayer insulating layer ITL1 may include an inorganic layer, for example, a silicon nitride layer, a silicon oxynitride layer, a silicon oxide layer, a titanium oxide layer, or an aluminum oxide layer. The first interlayer insulating layer ITL1 may include a plurality of inorganic layers.

A fifth pattern layer may be located on the first interlayer insulating layer ITL1. For example, a second active layer ACT2 may be located on the first interlayer insulating layer ITL1. As illustrated in FIG. 8, the second active layer ACT2 may be located on the first interlayer insulating layer ITL1 to overlap the third counter gate electrode GEb3. The second active layer ACT2 may include a first electrode E31 of a third transistor T3, a second electrode E32 of the third transistor T3, and a third channel region CH3 of the third transistor T3. The third channel region CH3 of the second active layer ACT2 may overlap the third counter gate electrode GEb3.

The second active layer ACT2 may be an oxide-based active layer. For example, the second active layer ACT2 may be an oxide semiconductor including indium-gallium-zinc-oxide (IGZO) or indium-gallium-zinc-tin oxide (IGZTO).

A third gate insulating layer GTI3 may be located on the fifth pattern layer. For example, as illustrated in FIG. 8, the third gate insulating layer GTI3 may be located on the second active layer ACT2. The third gate insulating layer GTI3 may be arranged on the entire surface of the substrate SUB including the second active layer ACT2.

The third gate insulating layer GTI3 may have the same material and structure as the first gate insulating layer GTI1 described above.

A sixth pattern layer may be located on the third gate insulating layer GTI3. For example, a fourth gate electrode GE4 and a third gate electrode GE3 may be located on the third gate insulating layer GTI3.

FIG. 8 shows an example in which the third gate electrode GE3 is located on the third gate insulating layer GTI3. The third gate electrode GE3 may overlap the third channel region CH3 of the second active layer ACT2.

The sixth pattern layer may have the same material or structure as the third pattern layer described above.

A second interlayer insulating layer ITL2 may be located on the sixth pattern layer. For example, as illustrated in FIG. 8, the second interlayer insulating layer ITL2 may be located on the third gate electrode GE3. The second interlayer insulating layer ITL2 may be located on the entire surface of the substrate SUB including the third gate electrode GE3.

The second interlayer insulating layer ITL2 may have the same material and structure as the first interlayer insulating layer ITL1 described above.

A seventh pattern layer may be located on the second interlayer insulating layer ITL2. For example, a first initialization voltage line VIL1, a third gate line GIL, a data connection electrode DCE, a first gate line GWL, a second gate line GCL, a gate connection electrode GCE, an active connection electrode ACE, a bias voltage line VBL, a capacitor connection electrode CCE, a lower pixel connection electrode PCEa, a fourth gate line EBL, and a second initialization voltage line VIL2 may be located on the second interlayer insulating layer ITL2.

FIG. 8 shows an example in which the gate connection electrode GCE, the active connection electrode ACE, the bias voltage line VBL, and the lower pixel connection electrode PCEa are located on the second interlayer insulating layer ITL2. The lower pixel connection electrode PCEa may be connected to the second electrode E62 of the sixth transistor T6 through a first contact hole CT1 penetrating the second interlayer insulating layer ITL2, the third gate insulating layer GTI3, the first interlayer insulating layer ITL1, the second gate insulating layer GTI2, and the first gate insulating layer GTI1. The active connection electrode ACE may be connected to the second electrode E12 of the first transistor T1 and the first electrode E61 of the sixth transistor T6 through a second contact hole CT2 penetrating the second interlayer insulating layer ITL2, the third gate insulating layer GTI3, the first interlayer insulating layer ITL1, the second gate insulating layer GTI2, and the first gate insulating layer GTI1. In addition, the active connection electrode ACE may be connected to the second electrode E32 of the third transistor T3 through a fifth contact hole CT5 penetrating the second interlayer insulating layer ITL2 and the third gate insulating layer GTI3. The gate connection electrode GCE may be connected to the first gate electrode GE1 through a third contact hole CT3 penetrating the second interlayer insulating layer ITL2, the third gate insulating layer GTI3, the first interlayer insulating layer ITL1, a hole 40 of the capacitor electrode CPE, and the second gate insulating layer GTI2. In addition, the gate connection electrode GCE may be connected to the first electrode E31 of the third transistor T3 through a fourth contact hole CT4 penetrating the second interlayer insulating layer ITL2 and the third gate insulating layer GTI3.

The seventh pattern layer may have the same material or structure as the third pattern layer described above.

A first planarization layer VA1 may be located on the seventh pattern layer. For example, the first planarization layer VA1 may be located on the gate connection electrode GCE, the active connection electrode ACE, the bias voltage line VBL, and the lower pixel connection electrode PCEa. The first planarization layer VA1 may be arranged on the entire surface of the substrate SUB including the gate connection electrode GCE, the active connection electrode ACE, the bias voltage line VBL, and the lower pixel connection electrode PCEa.

The first planarization layer VA1 may include an organic layer such as acryl resin, epoxy resin, phenolic resin, polyamide resin, or polyimide resin.

An eighth pattern layer may be located on the first planarization layer VA1. For example, a first data line DL1, a driving voltage line VDL, and an upper pixel connection electrode PCEb may be located on the second interlayer insulating layer ITL2. FIG. 8 shows an example in which the driving voltage line VDL and the upper pixel connection electrode PCEb are located on the first planarization layer VA1.

The upper pixel connection electrode PCEb may be connected to the lower pixel connection electrode PCEa through a sixth contact hole CT6 penetrating the first planarization layer VA1.

The eighth pattern layer may have the same material or structure as the third pattern layer described above.

A second planarization layer VA2 may be located on the eighth pattern layer. For example, the second planarization layer VA2 may be located on the driving voltage line VDL and the upper pixel connection electrode PCEb. The second planarization layer VA2 may be arranged on the entire surface of the substrate SUB including the driving voltage line VDL and the upper pixel connection electrode PCEb.

The second planarization layer VA2 may have the same material and structure as the first planarization layer VA1 described above.

A ninth pattern layer may be located on the second planarization layer VA2. For example, as illustrated in FIG. 8, the light emitting element layer EMTL including the ninth pattern layer may be located on the second planarization layer VA2. For example, as illustrated in FIG. 8, a pixel electrode PE may be formed as the ninth pattern layer on a third planarization layer VA3. The pixel electrode PE may be connected to the upper pixel connection electrode PCEb through a seventh contact hole CT7 penetrating the second planarization layer VA2.

The light emitting element layer EMTL may further include a light emitting element LEL and a bank PDL (or a pixel defining layer) in addition to the ninth pattern layer described above.

The light emitting element LEL may include the pixel electrode PE, the light emitting layer EL, and a common electrode CM. An emission area EA is an area where the pixel electrode PE, the light emitting layer EL, and the common electrode CM are sequentially stacked so that holes from the pixel electrode PE and electrons from the common electrode CM are combined with each other in the light emitting layer EL to emit light. In this case, the pixel electrode PE may be an anode of the light emitting element LEL, and the common electrode CM may be a cathode of the light emitting element LEL.

In a top emission structure in which light is emitted in a direction from the light emitting layer EL toward the common electrode CM, the pixel electrode PE may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/AI/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The bank PDL (or the pixel defining layer) may define emission areas EA of pixels PX. To this end, the bank PDL may be located on the third planarization layer VA3 to expose a portion of the pixel electrode PE. The bank PDL may cover edges of the pixel electrode PE. The bank PDL may be located in the seventh contact hole CT7 penetrating the third planarization layer VA3. Accordingly, the seventh contact hole CT7 penetrating the third planarization layer VA3 may be filled with the bank PDL. The bank PDL may be made of an organic layer such as acryl resin, epoxy resin, phenolic resin, polyamide resin, or polyimide resin.

As illustrated in FIG. 8, a spacer SPC may be located on the bank PDL. The spacer SPC may support a mask during a process of manufacturing the light emitting layer EL. The spacer SPC may be made of an organic layer such as acryl resin, epoxy resin, phenolic resin, polyamide resin, or polyimide resin.

The light emitting layer EL may be formed on the pixel electrode PE. The light emitting layer EL may include an organic material to emit light of a color (e.g., a set or predetermined color). For example, the light emitting layer EL may include a hole transporting layer, an organic material layer, and an electron transporting layer. The organic material layer may include a host and a dopant. The organic material layer may include a material that emits light (e.g., a predetermined light) and may be formed using a phosphorescent material or a fluorescent material.

The light emitting element LEL described above may be provided for each pixel PX. For example, a first pixel PX may include a first light emitting element, a second pixel PX may include a second light emitting element, and a third pixel PX may include a third light emitting element. The first light emitting element, the second light emitting element, and the third light emitting element may provide light of different colors. For example, the first light emitting element may emit light of a first color, the second light emitting element may emit light of a second color, and the third light emitting element may emit light of a third color.

For example, an organic material layer of a first light emitting layer of a first emission area emitting light of the first color may be a phosphorescent material that includes a host material including carbazole biphenyl (CBP) or 1,3-bis(carbazol-9-yl) (mCP) and a dopant including any one or more of bis(1-phenylisoquinoline)acetylacetonate iridium (PIQIr(acac)), bis(1-phenylquinoline)acetylacetonate iridium (PQIr(acac)), tris (1-phenylquinoline)iridium (PQIr) and octaethylporphyrin platinum (PtOEP). Alternatively, the organic material layer of the first light emitting layer of the first emission area may be a fluorescent material including PBD:Eu(DBM)3(Phen) or perylene. However, the present disclosure is not limited thereto.

An organic material layer of a second light emitting layer of a second emission area emitting light of the second color may be a phosphorescent material that includes a host material including CBP or mCP and a dopant material including Ir(ppy)3(fac tris(2-phenylpyridine)iridium). Alternatively, the organic material layer of the second light emitting layer of the second emission area emitting light of the second color may be a fluorescent material including tris(8-hydroxyquinolino)aluminum (Alq3). However, the present disclosure is not limited thereto.

An organic material layer of a third light emitting layer of a third emission area emitting light of the third color may be a phosphorescent material that includes a host material including CBP or mCP and a dopant material including (4,6-F2ppy)2Irpic or L2BD111. However, the present disclosure is not limited thereto.

The common electrode CM may be located on the first, second, and third light emitting layers (e.g., EL). The common electrode CM may cover the first, second and third light emitting layers. The common electrode CM may be a common layer commonly located on the first through third light emitting layers. A capping layer may be formed on the common electrode CM.

In the top emission structure, the common electrode CM may be made of a transparent conductive material (TCO) that can transmit light, such as indium tin oxide (ITO) or indium zinc oxide (IZO), or a semi-transmissive conductive material such as magnesium (Mg), silver (Ag) or an alloy of Mg and Ag. When the common electrode CM is made of a semi-transmissive conductive material, light output efficiency may be increased by a microcavity.

The encapsulation layer ENC may be formed on the light emitting element layer EMTL. The encapsulation layer ENC may include at least one inorganic layer TFE1 and TFE3 to prevent or reduce penetration of contaminants such as oxygen or moisture into the light emitting element layer EMTL. In addition, the encapsulation layer ENC may include at least one organic layer to protect the light emitting element layer EMTL from foreign substances such as dust. For example, the encapsulation layer ENC may include a first encapsulating inorganic layer TFE1, an encapsulating organic layer TFE2, and a second encapsulating inorganic layer TFE3.

The first encapsulating inorganic layer TFE1 may be located on the common electrode CM, the encapsulating organic layer TFE2 may be located on the first encapsulating inorganic layer TFE1, and the second encapsulating inorganic layer TFE3 may be located on the encapsulating organic layer TFE2. Each of the first encapsulating inorganic layer TFE1 and the second encapsulating inorganic layer TFE3 may be a multilayer in which one or more inorganic layers selected from a silicon nitride layer, a silicon oxynitride layer, a silicon oxide layer, a titanium oxide layer, and an aluminum oxide layer are alternately stacked. The encapsulating organic layer TFE2 may be an organic layer such as acryl resin, epoxy resin, phenolic resin, polyamide resin, or polyimide resin.

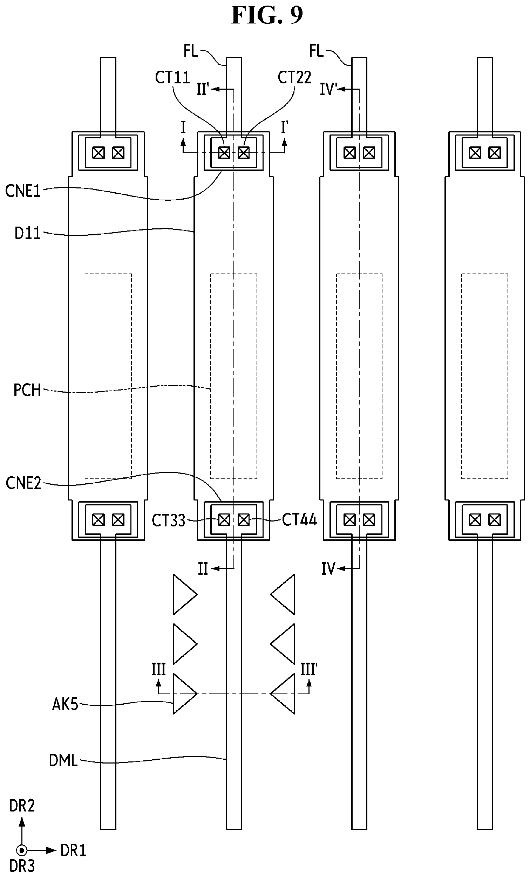

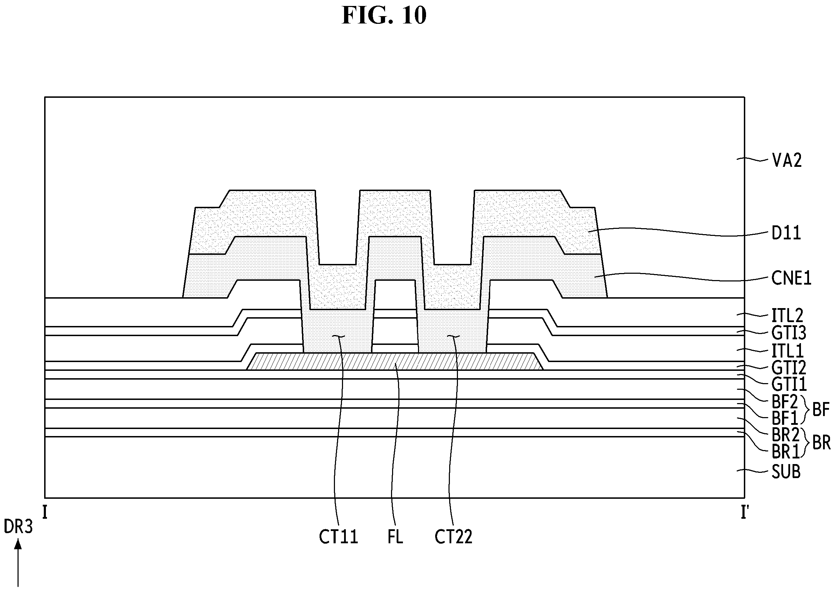

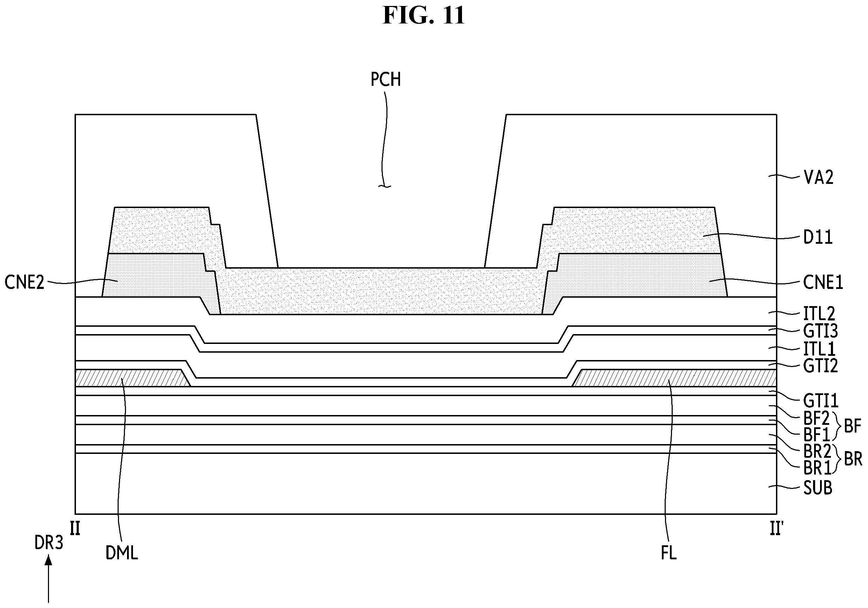

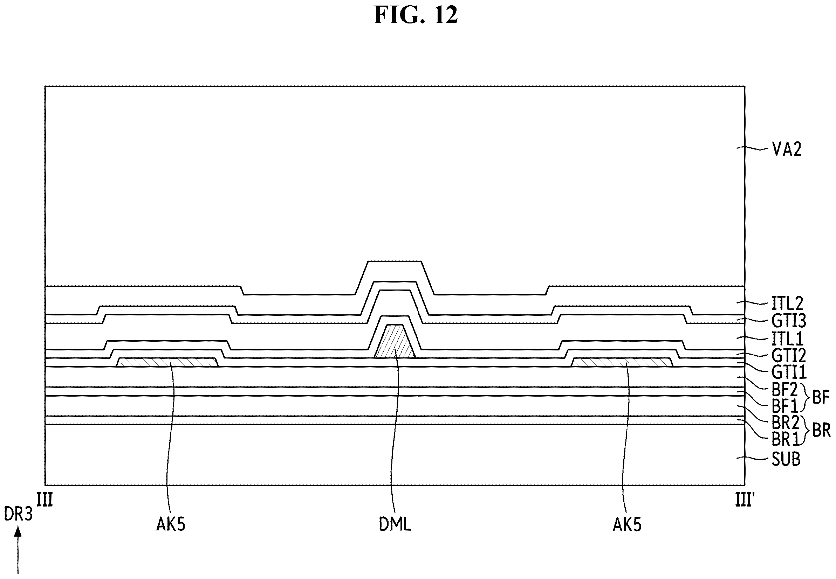

FIG. 9 is an enlarged view of the part A5 of FIG. 2. FIG. 10 is a cross-sectional view taken along the line I-I' of FIG. 9. FIG. 11 is a cross-sectional view taken along the line II-II' of FIG. 9. FIG. 12 is a cross-sectional view taken along the line III-III' of FIG. 9.

FIG. 9 shows four first pads (e.g., four first data pads D11). For example, the four first data pads D11 may be first data pads D11 connected to different first data lines.

A side of each first data pad D11 may be connected to a fan-out line FL, and the other side of each first data pad D11 may be connected to a dummy line DML. For example, each first data pad D11 may be connected to a fan-out line FL through a first connection electrode CNE1 and may be connected to a dummy line DML through a second connection electrode CNE2. The dummy line DML may be a part of a test line for transmitting a test signal during a process of manufacturing the display device 100. For example, after a process of testing the display device 100 through the test line is completed, the test line may be cut in a scribing process. Therefore, the dummy line DML may be a part of the cut test line.

The fan-out line FL and the dummy line DML may be located on the first gate insulating layer GTI1. The fan-out line FL and the dummy line DML may each be made of the same material as the third pattern layer described above.

The first connection electrode CNE1 may be located on the fan-out line FL, and the second connection electrode CNE2 may be located on the dummy line DML. For example, the first connection electrode CNE1 may be located on the second interlayer insulating layer ITL2 to overlap the fan-out line FL, and the second connection electrode CNE2 may be located on the second interlayer insulating layer ITL2 to overlap the dummy line DML. The first connection electrode CNE1 may be connected to the fan-out line FL through a first contact hole CT11 and a second contact hole CT22 penetrating the second interlayer insulating layer ITL2, the third gate insulating layer GTI3, the first interlayer insulating layer ITL1, and the second gate insulating layer GTI2. The second connection electrode CNE2 may be connected to the dummy line DML through a third contact hole CT33 and a fourth contact hole CT44 penetrating the second interlayer insulating layer ITL2, the third gate insulating layer GTI3, the first interlayer insulating layer ITL1, and the second gate insulating layer GTI2. The first connection electrode CNE1 and the second connection electrode CNE2 may each be made of the same material as the seventh pattern layer described above.

Each first data pad D11 may be located on the first connection electrode CNE1 and the second connection electrode CNE2. For example, each first data pad D11 may be located on the first connection electrode CNE1 and the second connection electrode CNE2 to overlap the first connection electrode CNE1 and the second connection electrode CNE2. Each first data pad D11 may be directly connected to (or directly in contact with) the first connection electrode CNE1 and the second connection electrode CNE2. The first data pads D11 may be made of the same material as the eighth pattern layer described above.

The second planarization layer VA2 may be located on the first data pads D11. The second planarization layer VA2 may have a pad contact hole PCH which exposes at least a portion of each first data pad D11. For example, the pad contact hole PCH may penetrate the second planarization layer VA2. A terminal (e.g., a first data terminal D1) described above may be connected to each first data pad D11 through the pad contact hole PCH. For example, the first data terminal D1 may be electrically connected to each first data pad D11 through an anisotropic conductive layer located on the pad contact hole PCH.

Meanwhile, fifth alignment keys AK5 may be located in the non-display area NDA. For example, the fifth alignment keys AK5 may be located in the non-display area NDA between adjacent dummy lines DML. The fifth alignment keys AK5 may be marks for alignment between the circuit boards CB1 through CB5 and the display panel 110. For example, the fifth alignment keys AK5 may be marks for alignment between the terminals C1, P1, D1, P2, D2, P3, D3, P4, D4, P5, D5 and C2 of the circuit boards CB1 through CB5 and the pads C11, P11, D11, P22, D22, P33, D33, P44, D44, P55, D55 and C22 of the display panel 110. Through the fifth alignment keys AK5, the terminals C1, P1, D1, P2, D2, P3, D3, P4, D4, P5, D5 and C2 can be aligned with the pads C11, P11, D11, P22, D22, P33, D33, P44, D44, P55, D55 and C22. In addition, through the fifth alignment keys AK5, it can be checked whether the terminals C1, P1, D1, P2, D2, P3, D3, P4, D4, P5, D5 and C2 are accurately aligned with the pads C11, P11, D11, P22, D22, P33, D33, P44, D44, P55, D55 and C22. The fifth alignment keys AK5 may have, for example, a triangular shape.

The fifth alignment keys AK5 may be located on both sides of a dummy line DML. For example, a plurality of fifth alignment keys AK5 may be arranged opposite each other with the dummy line DML between them. A fifth alignment key AK5 located on one side of the dummy line DML and a fifth alignment key AK5 located on the other side of the dummy line DML may be symmetrical with respect to the dummy line DML between them.

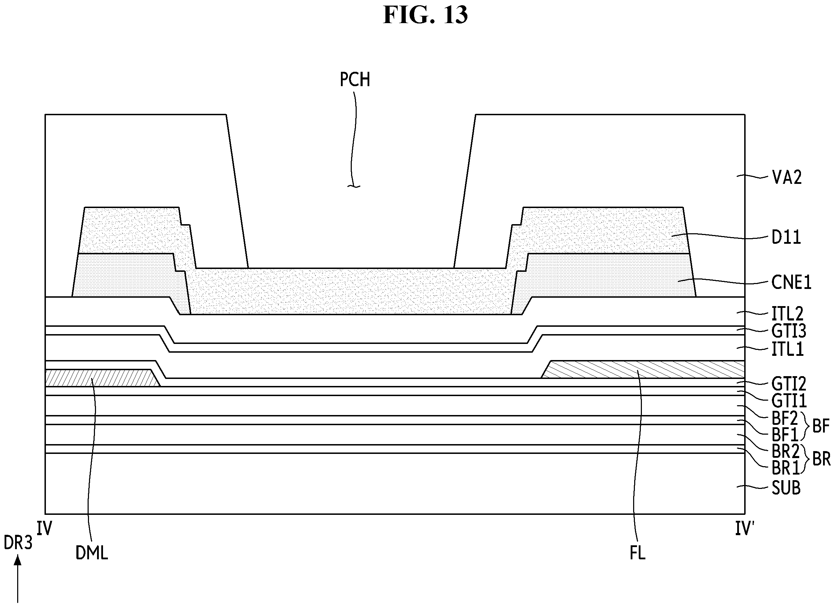

The fifth alignment keys AK5 may be located on the buffer layer BF. For example, the fifth alignment keys AK5 may be located between the second buffer layer BF2 and the first gate insulating layer GTI1. The fifth alignment keys AK5 may be made of the same material as the second pattern layer described above. For example, the fifth alignment keys AK5 may be made of the same material as the first active layer ACT1 described above. Specifically, the fifth alignment keys AK5 may be made of the same material as the first electrode E61 of the first active layer ACT1. The fifth alignment keys AK5 can be observed from the back of the substrate SUB. FIG. 13 is a cross-sectional view taken along the line IV-IV' of FIG. 9.

A display device 100 of FIG. 13 is different from the above-described display device 100 of FIG. 9 in that a fan-out line FL is located on a first gate insulating layer GTI1. This difference will be mainly described as follows.

As illustrated in FIG. 13, the fan-out line FL may be located on the first gate insulating layer GTI1. For example, the fan-out line FL may be made of the same material as the fourth pattern layer described above.

As illustrated in FIG. 13, adjacent fan-out lines FL may be located on different layers. For example, one of the adjacent fan-out lines FL may be made of the third pattern layer, and the other may be made of the fourth pattern layer. In other words, when the fan-out line FL made of the third pattern layer is defined as a first fan-out line and the fan-out line FL made of the fourth pattern layer is defined as a second fan-out line, the first fan-out line and the second fan-out line may be arranged alternately along the first direction DR1.

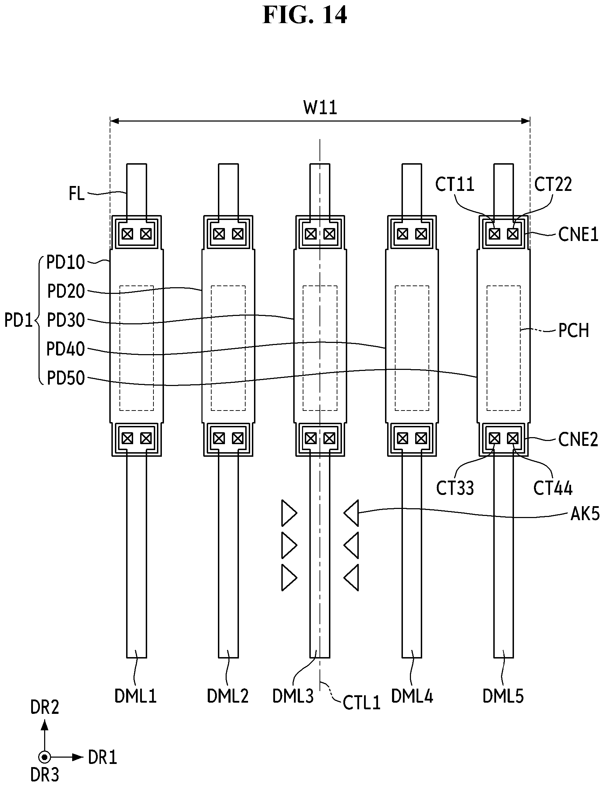

FIG. 14 is a diagram illustrating the position of fifth alignment keys AK5 when the number of pads in a group pad is an odd number.

FIG. 14 shows an example in which one group pad (e.g., PD1) includes five pads PD10, PD20, PD30, PD40, and PD50. Here, a first dummy line DML1 may be connected to a first pad PD10, a second dummy line DML2 may be connected to a second pad PD20, a third dummy line DML3 may be connected to a third pad PD30, a fourth dummy line DML4 may be connected to a fourth pad PD40, and a fifth dummy line DML5 may be connected to a fifth pad PD50.

As illustrated in FIG. 14, the fifth alignment keys AK5 may be located near an imaginary center line CTL1 passing through a portion of the group pad PD1, which corresponds to a half of a width W11 of the group pad PD1, and extending parallel to a pad (e.g., PD30) along the second direction DR2 (e.g., a direction in which the pad extends). For example, as illustrated in FIG. 14, when the total number of pads PD10, PD20, PD30, PD40 and PD50 included in the group pad PD1 is an odd number (e.g., five), the center line CTL1 may be located at a center of the third pad PD30 located at a center of the group pad PD1. Here, the fifth alignment keys AK5 may be located on both sides of the third dummy line DML3 connected to the third pad PD30. For example, the fifth alignment keys AK5 may face each other in the first direction DR1 with the third dummy line DML3 interposed between them. In other words, three of the fifth alignment keys AK5 may be located between the second dummy line DML2 and the third dummy line DML3, and the other three of the fifth alignment keys AK5 may be located between the third dummy line DML3 and the fourth dummy line DML4.

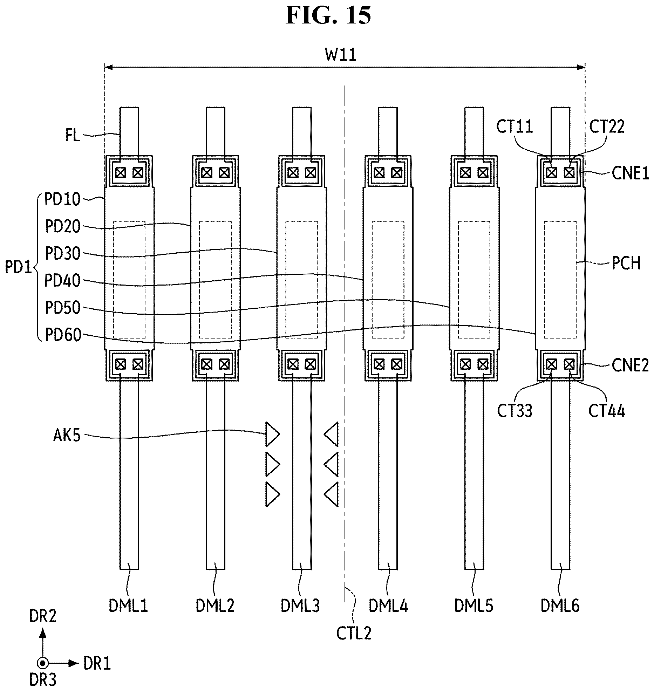

FIG. 15 is a diagram illustrating the position of fifth alignment keys AK5 when the number of pads in a group pad is an even number.

FIG. 15 shows an example in which one group pad (e.g., PD1) includes six pads PD10, PD20, PD30, PD40, PD50, and PD60. Here, a first dummy line DML1 may be connected to a first pad PD10, a second dummy line DML2 may be connected to a second pad PD20, a third dummy line DML3 may be connected to a third pad PD30, a fourth dummy line DML4 may be connected to a fourth pad PD40, a fifth dummy line DML5 may be connected to a fifth pad PD50, and a sixth dummy line DML6 may be connected to a sixth pad PD60.

As illustrated in FIG. 15, the fifth alignment keys AK5 may be located near an imaginary center line CTL2 passing through a portion of the group pad PD1, which corresponds to a half of a width W11 of the group pad PD1, and extending parallel to a pad (e.g., PD30) along the second direction DR2 (e.g., a direction in which the pad extends). For example, as illustrated in FIG. 15, when the total number of pads PD10, PD20, PD30, PD40, PD50 and PD60 included in the group pad PD1 is an even number (e.g., six), the center line CTL2 may be located between the third pad PD30 and the fourth pad PD40 located at a center of the group pad PD1. Here, the fifth alignment keys AK5 may be located on both sides of the third dummy line DML3 located first to the left (e.g., a reverse direction (hereinafter, referred to as a first reverse direction) of the first direction DR1) of the center line CTL2. For example, the fifth alignment keys AK5 may face each other in the first direction DR1 with the third dummy line DML3 interposed between them. In other words, three of the fifth alignment keys AK5 may be located between the center line CTL2 (or the fourth dummy line DML4) and the third dummy line DML3, and the other three of the fifth alignment keys AK5 may be located between the third dummy line DML3 and the second dummy line DML2.

When the total number of pads PD10, PD20, PD30, PD40, PD50 and PD60 included in the group pad PD1 is an even number as described above, the fifth alignment keys AK5 may be located on both sides of the fourth dummy line DML4 located first to the right (e.g., the first direction DR1) of the center line CTL2. For example, the fifth alignment keys AK5 may face each other in the first direction DR1 with the fourth dummy line DML4 interposed between them. In other words, three of the fifth alignment keys AK5 may be located between the center line CTL2 (or the third dummy line DML3) and the fourth dummy line DML4, and the other three of the fifth alignment keys AK5 may be located between the fourth dummy line DML4 and the fifth dummy line DML5.

When the total number of pads PD10, PD20, PD30, PD40, PD50 and PD60 included in the group pad PD1 is an even number as described above, the fifth alignment keys AK5 may be located on both sides of an n^{th} dummy line to the left (e.g., the first reverse direction) of the center line CTL2 or may be located on both sides of an n^{th} dummy line to the right (e.g., the first direction DR1) of the center line CTL2. Here, n may be a natural number, for example, a natural number less than k/2, where k may be the total number of pads included in one group pad. For example, as illustrated in FIG. 15, when the group pad PD1 includes a total of 6 pads PD10, PD20, PD30, PD40, PD50 and PD60, k is 3 (=6/2), and thus, n may be 1 or 2 *(k* is 6, and thus, n may be 1 or 2 which is less than 3 (=6/2)).

In the display device as described above, misalignment of a circuit board can be minimized or reduced at high resolution.

In concluding the detailed description, those skilled in the art will appreciate that many variations and modifications can be made to the disclosed embodiments without substantially departing from the principles of the present invention as set out in the appended claims. Therefore, the disclosed embodiments are used in a generic and descriptive sense only and not for purposes of limitation.

## Claims

1. A display device comprising:
a display panel (110);
a pixel in a display area of the display panel;
a plurality of circuit boards (CB1 - CB5) connected to a non-display area of the display panel; and
a plurality of driving circuits (DDC1 - DDC5) on the circuit boards,
wherein each of the circuit boards comprises a group terminal (BP1 - BP5) connected to pads of the non-display area, the group terminal comprises a plurality of terminals adjacent to each other on a corresponding circuit board, and group terminals of at least two circuit boards have different widths.

2. The display device of claim 1, wherein the circuit boards comprise:
a first outermost circuit board;
a second outermost circuit board; and
a middle circuit board between the first outermost circuit board and the second outermost circuit board.

3. The display device of claim 2, wherein a group terminal of at least one of the first outermost circuit board or the second outermost circuit board and a group terminal of the middle circuit board have different widths.

4. The display device of claim 3, wherein a width of the group terminal of the middle circuit board is smaller than a width of the group terminal of the at least one of the first outermost circuit board or the second outermost circuit board.

5. The display device of claim 3 or 4, further comprising a first alignment key between adjacent circuit boards.

6. The display device of claim 5, wherein the first alignment key is between one of the first and second outermost circuit boards and the middle circuit board.

7. The display device of claim 6, wherein the distance between any one of facing sides of the one outermost circuit board and the middle circuit board and the center of the first alignment key is equal to the distance between the other one of the facing sides and the center of the first alignment key, and/or wherein the distance between any one of facing sides of a terminal of the one outermost circuit board and a terminal of the middle circuit board and the center of the first alignment key is different from the distance between the other one of the facing sides and the center of the first alignment key.

8. The display device of claim 7, wherein the any one of the facing sides is a side of the terminal of the one outermost circuit board, and the other one of the facing sides is a side of the terminal of the one outermost circuit board.

9. The display device of claim 7, wherein the distance between the any one of the facing sides and the first alignment key is greater than the distance between the other one of the facing sides and the first alignment key, optionally wherein the distance is measured to the center of the first alignment key.

10. The display device of claim 7, wherein the pads comprise an outermost group pad connected to the first outermost circuit board and a middle group pad connected to the middle circuit board, and a distance between any one of facing sides of a pad included in the outermost group pad and a pad included in the middle group pad and the center of the first alignment key is different from a distance between the other one of the facing sides and the center of the first alignment key.

11. The display device of claim 5, wherein the middle circuit board comprises a first middle circuit board and a second middle circuit board, and the first alignment key is between the first middle circuit board and the second middle circuit board.

12. The display device of claim 11, wherein a distance between any one of facing sides of the first middle circuit board and the second middle circuit board and the center of the first alignment key is equal to a distance between the other one of the facing sides and the center of the first alignment key, and/or wherein a distance between any one of facing sides of a terminal of the first middle circuit board and a terminal of the second middle circuit board and the center of the first alignment key is equal to a distance between the other one of the facing sides and the center of the first alignment key.

13. The display device of any one of the preceding claims, wherein at least two of the circuit boards have different widths, wherein circuit boards having group terminals of different widths have different widths, and wherein a circuit board comprising a group terminal having a greater width has a greater width than a circuit board comprising a group terminal having a smaller width.

14. The display device of any one of the preceding claims, further comprising a second alignment key between adjacent dummy lines that are connected to the other side of each of the pads, optionally wherein the second alignment key has a triangular shape.

15. The display device of claim 14, wherein the second alignment key is on the same layer as an active layer of the pixel.

16. The display device of claim 14 or 15, wherein a plurality of group pads comprising adjacent pads among the pads are connected to a plurality of group terminals, wherein the second alignment key comprises a plurality of alignment keys, and the alignment keys are near an imaginary center line passing through a portion of a group pad, which corresponds to half of a width of the group pad, and extending parallel to a pad along a direction in which the pad extends.

17. The display device of claim 16, wherein when a total number of pads included in the group pad is an odd number, the center line is located at the center of a center pad at the center of the group pad, and the alignment keys are on both sides of a dummy line connected to the center pad.

18. The display device of claim 16, wherein based on a total number of pads included in the group pad being an even number, the alignment keys are on both sides of an n-th dummy line to the left of the center line or to the right of the center line, where n is a natural number less than k/2, and k is the total number of pads included in the group pads.

19. The display device of claim 14, wherein the second alignment key comprises a plurality of alignment keys on both sides of a dummy line with the dummy line interposed therebetween, and each of the alignment keys have a triangular shape.

20. The display device of any one of the preceding claims, wherein gaps between adjacent circuit boards are equal.
